# EUROPEAN PATENT APPLICATION

(11) **EP 4 098 672 A1**
(43) Date of publication of application: **07.12.2022**
(21) Application number: 21748024.3
(22) Date of filing: 22.01.2021
(51) Int. Cl.: C08F 212/08, C09K 3/00, G03F 7/004, G03F 7/039, G03F 7/20

(54) **POSITIVE RESIST COMPOSITION, RESIST FILM, PATTERN FORMATION METHOD, AND METHOD FOR MANUFACTURING ELECTRONIC DEVICE**

(30) Priority: 31.01.2020 JP 2020015892
(71) Applicant: FUJIFILM Corporation, Tokyo 106-8620 (JP)
(72) Inventor: TAKADA, Akira, Haibara-gun, Shizuoka 421-0396 (JP); GOTO, Akiyoshi, Haibara-gun, Shizuoka 421-0396 (JP); YAGI, Kazunari, Haibara-gun, Shizuoka 421-0396 (JP); SHIRAKAWA, Michihiro, Haibara-gun, Shizuoka 421-0396 (JP); MARUMO, Kazuhiro, Haibara-gun, Shizuoka 421-0396 (JP)
(74) Representative: HGF
(86) International application number: PCT/JP2021/002339
(87) International publication number: WO 2021/153466

(57) **Abstract**

The present invention provides a positive tone resist composition containing (A) an ionic compound and (B) a resin that has a repeating unit (b1) having an interactive group which interacts with an ionic group in the ionic compound and of which a main chain is decomposed by an irradiation with X-rays, electron beam, or extreme ultraviolet rays; a resist film formed of the positive tone resist composition; a pattern forming method; and a method for manufacturing an electronic device.

## Description

### BACKGROUND OF THE INVENTION

### 1. Field of the Invention

The present invention relates to a positive tone resist composition, a resist film, a pattern forming method, and a method for manufacturing an electronic device.

### 2. Description of the Related Art

Since an advent of a resist for KrF excimer laser (248 nm), a pattern forming method utilizing chemical amplification has been used in order to compensate for a decrease in sensitivity due to light absorption. For example, in a positive tone chemical amplification method, first, a photoacid generator included in an exposed portion is decomposed by irradiation with light to generate an acid. Then, in a post-exposure baking (PEB) process and the like, a solubility in a developer changes by, for example, changing an alkali-insoluble group which is included in a resin included in an actinic ray-sensitive or radiation-sensitive resin composition to an alkali-soluble group by a catalytic action of the generated acid. Thereafter, development is performed using a basic aqueous solution, for example. As a result, the exposed portion is removed to obtain a desired pattern.

On the other hand, a pattern forming method which does not utilize the chemical amplification using an acid as described above is also known.

Under these circumstances, various configurations have been proposed as the actinic ray-sensitive or radiation-sensitive resin composition.

For example, JP2017-146521A discloses a positive tone pattern resist material for forming a positive tone pattern by an organic solvent development, which includes a base resin including a polymer having a repeating unit having an ionic group.

JP2013-127526A discloses a resist composition used for a method for forming a specific resist pattern, which contains a base material component having an acidic group and an ionic compound having light absorption and generating an acid with an acid dissociation constant (pKa) of 0 or more by exposure, in which the acidic group and the cation having light absorption can form an association structure.

JP2017-132965A discloses a polymer which can sufficiently suppress occurrence of resist pattern collapse in a case of being used as a main chain cutting type positive tone resist and has high clarity of a resist pattern to be obtained; and a positive tone resist composition which includes the polymer and a solvent.

In addition, JP1991-132760A (JP-H3-132760A) discloses a pattern forming method using a resist consisting of a copolymer of α-methylstyrene and methyl α-chloroacrylate.

### SUMMARY OF THE INVENTION

In the pattern forming method using the chemical amplification using an acid, with the diffusion of acid from the exposed portion to the non-exposed portion, it is difficult to form a resist pattern according to an optical image, but according to the above-described pattern forming method which does not utilize the chemical amplification using an acid, such a property can be resolved.

However, in a pattern forming method using X-rays, electron beam (EB), or extreme ultraviolet rays (EUV light) as an exposure light source, there is a demand for ultra-miniaturization of the pattern, and even with the above-described techniques in the related art, resolution is insufficient in a formation of ultrafine pattern (for example, 40 nm or less).

Therefore, an object of the present invention is to provide a positive tone resist composition with which, in a formation of ultrafine pattern (for example, 40 nm or less), it is possible to form a pattern having extremely excellent resolution.

In addition, another object of the present invention is to provide a resist film formed of the positive tone resist composition, a pattern forming method, and a method for manufacturing an electronic device.

The present inventors have conducted intensive studies to achieve the above-described objects, and as a result, they have found that the above-described objects can be achieved by the following configurations.
[1] A positive tone resist composition comprising:
   (A) an ionic compound; and
   (B) a resin that has a repeating unit (b1) having an interactive group which interacts with an ionic group in the ionic compound and of which a main chain is decomposed by an irradiation with X-rays, electron beam, or extreme ultraviolet rays.
[2] The positive tone resist composition according to [1],
   in which the resin (B) has, as the interactive group, at least one selected from the group consisting of a hydroxyl group, an amino group, an amide group, and a thiol group.
[3] The positive tone resist composition according to [1] or [2],
   in which the resin (B) has a repeating unit represented by the following General Formula (1). 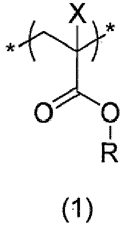 In the General Formula (1),
   X represents a halogen atom or a fluoroalkyl group, and
   R represents a hydrogen atom or a monovalent organic group.
[4] The positive tone resist composition according to [3],
   in which X in the General Formula (1) represents a fluorine atom, a chlorine atom, or a bromine atom.
[5] The positive tone resist composition according to any one of [1] to [4],
   in which the ionic compound (A) and the resin (B) are the same compound.
[6] The positive tone resist composition according to [5],
   in which the resin (B) has a repeating unit represented by the following General Formula (3) as the repeating unit (b1), and has at least one repeating unit selected from the group consisting of a repeating unit represented by the following General Formula (4) and a repeating unit represented by the following General Formula (5). 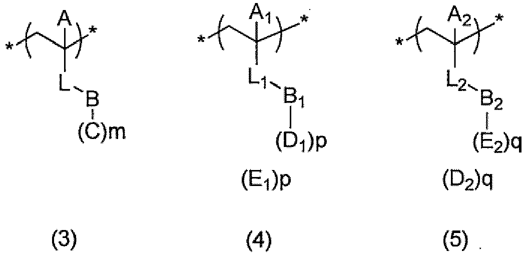 In the General Formula (3),
   A represents a hydrogen atom, a halogen atom, or an alkyl group,
   L represents a divalent linking group,
   B represents a single bond or an (m+1)-valent linking group,
   C represents the interactive group,
   m represents an integer of 1 or more, and
   in a case where m is an integer of 2 or more, a plurality of C's may be the same or different from each other,
   in the General Formula (4),
   A₁ represents a hydrogen atom, a halogen atom, or an alkyl group,
   L₁ represents a single bond or a divalent linking group,
   B₁ represents a single bond or a (p+1)-valent linking group,
   D₁ represents an anionic group,
   E₁ represents a cation,
   p represents an integer of 1 or 2, and
   in a case where p is an integer of 2, a plurality of D₁'s and a plurality of E₁'s each may be the same or different from each other, and
   in the General Formula (5),
   A₂ represents a hydrogen atom, a halogen atom, or an alkyl group,
   L₂ represents a divalent linking group,
   B₂ represents a single bond or a (q+1)-valent linking group,
   D₂ represents an anion,
   E₂ represents a cationic group,
   q represents an integer of 1 or 2, and
   in a case where q is an integer of 2, a plurality of D₂'s and a plurality of E₂'s each may be the same or different from each other.
[7] The positive tone resist composition according to any one of [1] to [6],
   in which the repeating unit (b1) is a repeating unit represented by General Formula (2). 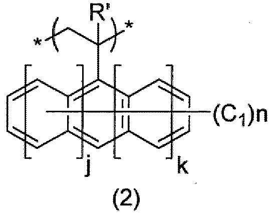 In General Formula (2),
   R' represents a hydrogen atom or an alkyl group,
   C₁ represents the interactive group,
   j represents 0 or 1,
   k represents 0 or 1,
   n represents an integer of 1 to 9, and
   in a case where n is an integer of 2 to 9, a plurality of C₁'s may be the same or different from each other.
[8] The positive tone resist composition according to any one of [1] to [7],
   in which a content of the repeating unit (b1) is 20 mol% or less with respect to all repeating units of the resin (B).
[9] The positive tone resist composition according to any one of [1] to [8],
   in which the resin (B) has a repeating unit represented by the following General Formula (7) (excluding a repeating unit corresponding to a repeating unit represented by the General Formula (2)). 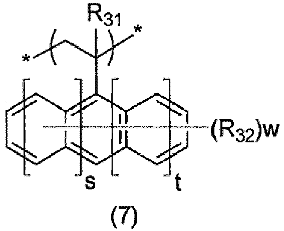 In the General Formula (7),
   R₃₁ represents a hydrogen atom or an alkyl group,
   R₃₂ represents a monovalent organic group,
   s represents 0 or 1,
   t represents 0 or 1,
   w represents an integer of 0 to 9, and
   in a case where w is an integer of 2 to 9, a plurality of R₃₂'s may be the same or different from each other.
[10] The positive tone resist composition according to any one of [1] to [9],
   in which the ionic compound (A) is a compound represented by the following General Formula (6). 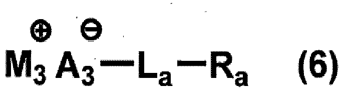 In the General Formula (6),
   M₃⁺ represents an organic cation which is decomposed by an irradiation with X-rays, electron beam, or extreme ultraviolet rays,
   A₃⁻ represents an anionic group,
   Rₐ represents a hydrogen atom or a monovalent organic group, and
   Lₐ represents a single bond or a divalent linking group.
[11] The positive tone resist composition according to [10],
   in which the ionic compound (A) and the resin (B) are the same compound, and
   the monovalent organic group as Rₐ in the compound represented by the General Formula (6) includes a main chain structure of the resin.
[12] The positive tone resist composition according to [10] or [11],
   in which A₃⁻ in the compound represented by the General Formula (6) is a group selected from the group consisting of groups represented by the following General Formulae (B-1) to (B-14). 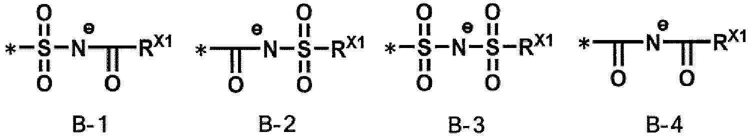 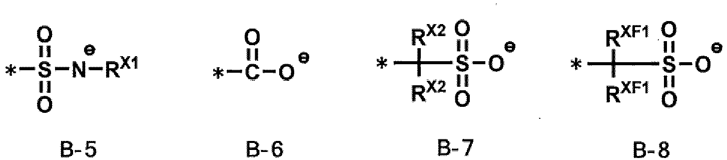 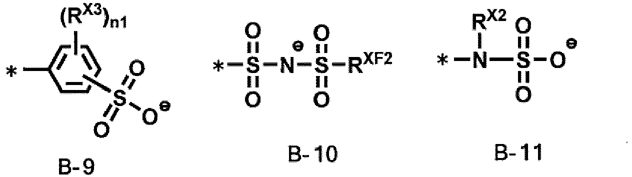 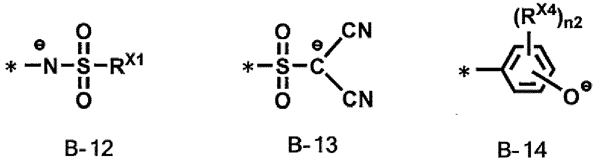 In the Formulae (B-1) to (B-14), ^{∗} represents a bonding position,
   in the Formulae (B-1) to (B-5) and (B-12), R^{X1}'s each independently represent a monovalent organic group,
   in the Formulae (B-7) and (B-11), R^{X2}'s each independently represent a hydrogen atom or a substituent other than a fluorine atom and a perfluoroalkyl group; two R^{X2}'s in the Formula (B-7) may be the same or different from each other,
   in the General Formula (B-8), R^{XF1} represents a hydrogen atom, a fluorine atom, or a perfluoroalkyl group, at least one of a plurality of R^{XF1}'s represents a fluorine atom or a perfluoroalkyl group; and two R^{XF1}'s in the Formula (B-8) may be the same or different from each other,
   in the General Formula (B-9), R^{X3} represents a hydrogen atom, a halogen atom, or a monovalent organic group, n1 represents an integer of 0 to 4, and in a case where n1 represents an integer of 2 to 4, a plurality of R^{X3}'s may be the same or different from each other,
   in the General Formula (B-10), R^{XF2} represents a fluorine atom or a perfluoroalkyl group, and
   in the General Formula (B-14), R^{X4} represents a hydrogen atom, a halogen atom, or a monovalent organic group, n2 represents an integer of 0 to 4, and in a case where n2 represents an integer of 2 to 4, a plurality of R^{X4}'s may be the same or different from each other.
[13] The positive tone resist composition according to [12],
   in which A₃⁻ in the compound represented by the General Formula (6) is a group selected from the group consisting of the groups represented by the General Formulae (B-6), (B-7), (B-8), (B-9), and (B-14).
[14] A resist film formed of the positive tone resist composition according to any one of [1] to [13].
[15] A pattern forming method comprising:
   a step of forming a resist film on a substrate by the positive tone resist composition according to any one of [1] to [13];
   a step of exposing the resist film with X-rays, electron beam, or extreme ultraviolet rays; and
   a step of developing the exposed resist film by a developer to form a pattern.
[16] A method for manufacturing an electronic device, comprising:
   the pattern forming method according to [15].

According to the present invention, it is possible to provide a positive tone resist composition with which, in a formation of ultrafine pattern (for example, 40 nm or less), it is possible to form a pattern having extremely excellent resolution.

In addition, according to the present invention, it is possible to provide a resist film formed of the positive tone resist composition, a pattern forming method, and a method for manufacturing an electronic device.

### DESCRIPTION OF THE PREFERRED EMBODIMENTS

Hereinafter, a resist composition, a resist film, a pattern forming method, and a method for manufacturing an electronic device according to embodiments of the present invention will be described in detail.

Description of configuration requirements described below may be made on the basis of representative embodiments of the present invention in some cases, but the present invention is not limited to such embodiments.

In notations for a group (atomic group) in the present specification, in a case where the group is cited without specifying that it is substituted or unsubstituted, the group includes both a group having no substituent and a group having a substituent as long as it does not impair the spirit of the present invention. For example, an "alkyl group" includes not only an alkyl group having no substituent (unsubstituted alkyl group), but also an alkyl group having a substituent (substituted alkyl group). In addition, an "organic group" in the present specification refers to a group including at least one carbon atom.

A substituent is preferably a monovalent substituent unless otherwise specified.

In addition, in the present specification, the types of substituents, the positions of substituents, and the number of substituents in a case where it is described that "a substituent may be included" are not particularly limited. The number of substituents may be, for example, one, two, three, or more. Examples of the substituent include a monovalent non-metal atomic group from which a hydrogen atom has been excluded, and the substituent can be selected from the following substituent T, for example.

### (Substituent T)

Examples of the substituent T include halogen atoms such as a fluorine atom, a chlorine atom, a bromine atom, and an iodine atom; alkoxy groups such as a methoxy group, an ethoxy group, and a tert-butoxy group; aryloxy groups such as a phenoxy group and a p-tolyloxy group; alkoxycarbonyl groups such as a methoxycarbonyl group, a butoxycarbonyl group, and a phenoxycarbonyl group; acyloxy groups such as an acetoxy group, a propionyloxy group, and a benzoyloxy group; acyl groups such as an acetyl group, a benzoyl group, an isobutyryl group, an acryloyl group, a methacryloyl group, and a methoxalyl group; alkylsulfanyl groups such as a methylsulfanyl group and a tert-butylsulfanyl group; arylsulfanyl groups such as a phenylsulfanyl group and a p-tolylsulfanyl group; an alkyl group; a cycloalkyl group; an aryl group; a heteroaryl group; a hydroxyl group; a carboxyl group; a formyl group; a sulfo group; a cyano group; an alkylaminocarbonyl group; an arylaminocarbonyl group; a sulfonamide group; a silyl group; an amino group; a monoalkylamino group; a dialkylamino group and a nitro group; a formyl group; an arylamino group; and a combination thereof.

"Actinic ray" or "radiation" in the present specification means, for example, a bright line spectrum of a mercury lamp, far ultraviolet rays typified by an excimer laser, extreme ultraviolet rays (EUV light), X-rays, electron beams (EB), or the like. "Light" in the present specification means actinic ray or radiation.

Unless otherwise specified, "exposure" in the present specification encompasses not only exposure by a bright line spectrum of a mercury lamp, far ultraviolet rays typified by an excimer laser, extreme ultraviolet rays, X-rays, EUV light, or the like, but also drawing by particle beams such as electron beams and ion beams.

In the present specification, a numerical range expressed using "to" is used in a meaning of a range that includes the preceding and succeeding numerical values of "to" as the lower limit value and the upper limit value, respectively.

A bonding direction of a divalent group cited in the present specification is not limited unless otherwise specified. For example, in a case where Y in a compound represented by General Formula "X-Y-Z" is -COO-, Y may be -CO-O- or -O-CO-. In addition, the above-described compound may be "X-CO-O-Z" or "X-O-CO-Z".

In the present specification, (meth)acrylate represents acrylate and methacrylate, and (meth)acryl represents acryl and methacryl.

In the present specification, a weight-average molecular weight (Mw), a number-average molecular weight (Mn), and a dispersity (also referred to as a molecular weight distribution) (Mw/Mn) of a resin are defined as values expressed in terms of polystyrene by means of gel permeation chromatography (GPC) measurement (solvent: tetrahydrofuran, flow amount (amount of a sample injected): 10 µL, columns: TSK gel Multipore HXL-M manufactured by Tosoh Corporation, column temperature: 40°C, flow rate: 1.0 mL/min, and detector: differential refractive index detector) using a GPC apparatus (HLC-8120GPC manufactured by Tosoh Corporation).

In the present specification, an acid dissociation constant (pKa) represents a pKa in an aqueous solution, and is specifically a value determined by computation from a value based on a Hammett's substituent constant and database of publicly known literature values, using the following software package 1. Any of the pKa values described in the present specification indicates values determined by computation using the software package.

Software Package 1: Advanced Chemistry Development (ACD/Labs) Software V 8.14 for Solaris (1994 - 2007 ACD/Labs).

On the other hand, the pKa can also be determined by a molecular orbital computation method. Examples of a specific method therefor include a method for performing calculation by computing H⁺ dissociation free energy in an aqueous solution based on a thermodynamic cycle. With regard to a computation method for H⁺ dissociation free energy, the H⁺ dissociation free energy can be computed by, for example, density functional theory (DFT), but various other methods have been reported in literature and the like, and are not limited thereto. There are a plurality of software applications capable of performing DFT, and examples thereof include Gaussian 16.

As described above, the pKa in the present specification refers to a value determined by computation from a value based on a Hammett's substituent constant and database of publicly known literature values, using the software package 1, but in a case where the pKa cannot be calculated by the method, a value obtained by Gaussian 16 based on density functional theory (DFT) shall be adopted.

In addition, the pKa in the present specification refers to a "pKa in an aqueous solution" as described above, but in a case where the pKa in an aqueous solution cannot be calculated, a "pKa in a dimethyl sulfoxide (DMSO) solution" shall be adopted.

In the present specification, examples of the halogen atom include a fluorine atom, a chlorine atom, a bromine atom, and an iodine atom.

### [Positive Tone Resist Composition]

A positive tone resist composition (hereinafter, also referred to as a "resist composition") according to the embodiment of the present invention will be described.

The resist composition according to the embodiment of the present invention is a positive tone resist composition. In addition, the resist composition may be either a resist composition for alkali development or a resist composition for organic solvent development.

The composition according to the embodiment of the present invention is typically a non-chemically amplified resist composition.

The positive tone resist composition according to the embodiment of the present invention contains (A) an ionic compound and (B) a resin that has a repeating unit (b1) having an interactive group which interacts with an ionic group in the ionic compound and that a main chain is decomposed by an irradiation with X-rays, electron beam, or extreme ultraviolet rays.

According to such a configuration, it is possible to form a pattern having extremely excellent resolution in a formation of ultrafine pattern (for example, 40 nm or less).

Mechanism by which the present invention can exert the above-described effects is not always clear, but is considered to be as follows by the present inventors.

First, the resin (B) of the present invention is a resin in which a main chain is decomposed by irradiation with X-rays, electron beam, or extreme ultraviolet rays.

In a case where a resist film is formed of the resist composition according to the embodiment of the present invention and irradiated with X-rays, electron beam, or extreme ultraviolet rays, the main chain is cleaved in an exposed portion, and solubility in a developer is increased by reducing a molecular weight of the resin. That is, a difference in dissolution rate with respect to the developer (so-called dissolution contrast) occurs between the non-exposed portion and the exposed portion. Since the molecular weight of the above-described resin (B) is reduced, it is considered that the exposed portion has increased solubility in an alkali developer and also has increased solubility in an organic developer.

In addition, the resin (B) contains a repeating unit (b1) having an interactive group which interacts with an ionic group in the ionic compound.

In the resist film formed of the resist composition according to the embodiment of the present invention, since the ionic group and the interactive group interact with each other before the exposure, the resist film exhibits poor solubility in the developer. In a case of being irradiated with X-rays, electron beam, or extreme ultraviolet rays, in the exposed portion, for example, since the cation in the ionic compound absorbs the exposure light so that the ionic compound is decomposed, the interactive group is exposed and the solubility in the developer in the exposed portion is increased. That is, a dissolution contrast occurs between the non-exposed portion and the exposed portion. It is considered that the exposed portion has increased solubility in an alkali developer and also has increased solubility in an organic developer.

A specific aspect is shown below.

The above-described interactive group is a group which interacts with the above-described ionic group in the above-described ionic compound. Specifically, it is considered that the interactive group interacts with the above-described ionic group to form an association structure in a form close to a salt. In a case where a resist film is formed of the composition according to the embodiment of the present invention, in such an association structure, the resist film exhibits poor solubility in an alkali developer and also exhibits poor solubility in an organic developer.

The resist film is exposed to X-rays, electron beam (EB), or extreme ultraviolet rays (EUV light). Examples of an exposing method include a method in which the formed resist film is irradiated with X-rays, electron beam, or extreme ultraviolet rays through a predetermined mask. By the above-described exposure, the above-described cation is decomposed and the above-described interactive group forming the above-described association structure is exposed, and as a result, the solubility in the developer in the exposed portion is increased.

As described above, since the resin (B) contained in the resist composition according to the embodiment of the present invention is a resin in which the main chain is decomposed by irradiation with X-rays, electron beam, or extreme ultraviolet rays, and contains the above-described repeating unit (b1), the dissolution contrast between the exposed portion and the non-exposed portion can be significantly improved. Surprisingly, it is considered that a pattern having extremely excellent resolution can be formed even in the formation of ultrafine pattern (for example, 40 nm or less).

On the other hand, in a case where only a resin in which the main chain is decomposed as described above is used, or in a case where only the mechanism by the interaction as described above is used, in the formation of ultrafine pattern (for example, 40 nm or less), the dissolution contrast is still insufficient, and sufficient resolution cannot be obtained.

### [Components of Resist Composition]

Hereinafter, components that can be included in the resist composition will be described in detail.

### <(A) Ionic Compound>

The resist composition contains (A) an ionic compound (hereinafter, also referred to as a "compound (A)").

The compound (A) is typically a compound having an ionic group, and more specific examples of the compound include a compound having a cationic group and a counter anion as the ionic group and a compound having an anionic group and a counter cation as the ionic group.

Examples of the anionic group include a group having an anionic atom, and examples of the cationic group include a group including a cationic atom. Examples of the cation include an organic cation.

The compound (A) may have a cationic group and an anionic group in one molecule.

The above-described ionic compound (A) is preferably a compound represented by General Formula (6).

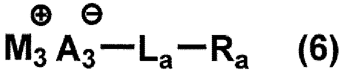

In General Formula (6),
M₃⁺ represents an organic cation which is decomposed by an irradiation with X-rays, electron beam, or extreme ultraviolet rays,
A₃⁻ represents an anionic group,
Rₐ represents a hydrogen atom or a monovalent organic group, and
Lₐ represents a single bond or a divalent linking group.

The monovalent organic group of Rₐ is not particularly limited, and as a preferred aspect, the number of carbon atoms is 1 to 30, preferably 1 to 20.

Rₐ is preferably an alkyl group, a cycloalkyl group, or an aryl group.

The alkyl group may be linear or branched, and an alkyl group having 1 to 20 carbon atoms is preferable, an alkyl group having 1 to 15 carbon atoms is more preferable, and an alkyl group having 1 to 10 carbon atoms is still more preferable.

The cycloalkyl group may be monocyclic or polycyclic, and a cycloalkyl group having 3 to 20 carbon atoms is preferable, a cycloalkyl group having 3 to 15 carbon atoms is more preferable, and a cycloalkyl group having 3 to 10 carbon atoms is still more preferable.

The aryl group may be monocyclic or polycyclic, and an aryl group having 6 to 20 carbon atoms is preferable, an aryl group having 6 to 15 carbon atoms is more preferable, and an aryl group having 6 to 10 carbon atoms is still more preferable.

The cycloalkyl group may include a heteroatom as a ring member atom. The heteroatom is not particularly limited, and examples thereof include a nitrogen atom and an oxygen atom.

In addition, the cycloalkyl group may include a carbonyl bond (>C=O) as a ring member atom.

The above-described alkyl group, cycloalkyl group, and aryl group may further have a substituent. The further substituent is not particularly limited, and the above-described substituent T is preferable.

The divalent linking group as La is not particularly limited, and represents an alkylene group, a cycloalkylene group, an aromatic group, -O-, -CO-, -COO-, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and examples thereof include the above-described substituent T, and a halogen atom is preferable.

A₃⁻ and Ra may be bonded to each other to form a ring.

M₃⁺ is not particularly limited, but an organic cation (cation (ZaI)) represented by General Formula (ZaI) or an organic cation (cation (ZaII)) represented by General Formula (ZaII) is preferable.

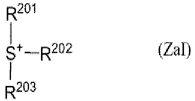

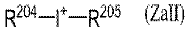

In General Formula (ZaI),
R²⁰¹, R²⁰² and R²⁰³ each independently represent an organic group.

The number of carbon atoms in the organic group of R²⁰¹, R²⁰², and R²⁰³ is usually 1 to 30, and preferably 1 to 20. In addition, two of R²⁰¹ to R²⁰³ may be bonded to each other to form a ring structure, and the ring structure may include an oxygen atom, a sulfur atom, an ester group, an amide group, or a carbonyl group in the ring. Examples of the group formed by the bonding of two of R²⁰¹ to R²⁰³ include an alkylene group (for example, a butylene group and a pentylene group) and -CH₂-CH₂-O-CH₂-CH₂-.

Examples of suitable aspects of the organic cation in General Formula (ZaI) include a cation (ZaI-1), a cation (ZaI-2), an organic cation (cation (Zal-3b)) represented by General Formula (Zal-3b), and an organic cation (cation (Zal-4b)) represented by General Formula (Zal-4b), each of which will be described later.

First, the cation (ZaI-1) will be described.

The cation (ZaI-1) is an arylsulfonium cation in which at least one of R²⁰¹, R²⁰², or R²⁰³ of General Formula (ZaI) is an aryl group.

In the arylsulfonium cation, all of R²⁰¹ to R²⁰³ may be aryl groups, or some of R²⁰¹ to R²⁰³ may be an aryl group and the rest may be an alkyl group or a cycloalkyl group.

In addition, one of R²⁰¹ to R²⁰³ may be an aryl group, the remaining two of R²⁰¹ to R²⁰³ may be bonded to each other to form a ring structure, and an oxygen atom, a sulfur atom, an ester group, an amide group, or a carbonyl group may be included in the ring. Examples of the group formed by the bonding of two of R²⁰¹ to R²⁰³ include an alkylene group (for example, a butylene group, a pentylene group, or -CH₂-CH₂-O-CH₂-CH₂-) in which one or more methylene groups may be substituted with an oxygen atom, a sulfur atom, an ester group, an amide group, and/or a carbonyl group.

Examples of the arylsulfonium cation include a triarylsulfonium cation, a diarylalkylsulfonium cation, an aryldialkylsulfonium cation, a diarylcycloalkylsulfonium cation, and an aryldicycloalkylsulfonium cation.

The aryl group included in the arylsulfonium cation is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium cation has two or more aryl groups, the two or more aryl groups may be the same or different from each other.

The alkyl group or the cycloalkyl group included in the arylsulfonium cation as necessary is preferably a linear alkyl group having 1 to 15 carbon atoms, a branched alkyl group having 3 to 15 carbon atoms, or a cycloalkyl group having 3 to 15 carbon atoms, and examples thereof include a methyl group, an ethyl group, a propyl group, an n-butyl group, a sec-butyl group, a t-butyl group, a cyclopropyl group, a cyclobutyl group, and a cyclohexyl group.

Examples of substituents which may be included in each of the aryl group, the alkyl group, and the cycloalkyl group of R²⁰¹ to R²⁰³ include an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkylalkoxy group (for example, having 1 to 15 carbon atoms), a halogen atom, a hydroxyl group, and a phenylthio group.

The substituent may further have a substituent if possible, and may be in a form of an alkyl halide group such as a trifluoromethyl group, for example, in which an alkyl group has a halogen atom as a substituent.

Next, the cation (ZaI-2) will be described.

The cation (ZaI-2) is a cation in which R²⁰¹ to R²⁰³ in Formula (ZaI) are each independently a cation representing an organic group having no aromatic ring. Here, the aromatic ring also encompasses an aromatic ring including a heteroatom.

The number of carbon atoms in the organic group as R²⁰¹ to R²⁰³, which has no aromatic ring, is generally 1 to 30, and preferably 1 to 20.

R²⁰¹ to R²⁰³ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

Examples of the alkyl group and cycloalkyl group of R²⁰¹ to R²⁰³ include a linear alkyl group having 1 to 10 carbon atoms or a branched alkyl group having 3 to 10 carbon atoms (for example, a methyl group, an ethyl group, a propyl group, a butyl group, and a pentyl group), and a cycloalkyl group having 3 to 10 carbon atoms (for example, a cyclopentyl group, a cyclohexyl group, and a norbornyl group).

R²⁰¹ to R²⁰³ may further be substituted with a halogen atom, an alkoxy group (for example, having 1 to 5 carbon atoms), a hydroxyl group, a cyano group, or a nitro group.

Next, the cation (Zal-3b) will be described.

The cation (Zal-3b) is a cation represented by General Formula (Zal-3b).

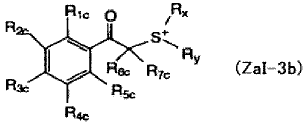

In General Formula (Zal-3b),
R_{1c} to R_{5c} each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group.
R_{6c} and R_{7c} each independently represent a hydrogen atom, an alkyl group (a t-butyl group and the like), a cycloalkyl group, a halogen atom, a cyano group, or an aryl group.
Rₓ and R_{y} each independently represent an alkyl group, a cycloalkyl group, a 2-oxoalkyl group, a 2-oxocycloalkyl group, an alkoxycarbonylalkyl group, an allyl group, or a vinyl group.

Any two or more of R_{1c}, ... , or R_{5c}, R_{5c} and R_{6c}, R_{6c} and R_{7c}, R_{5c} and Rₓ, and Rₓ and R_{y} may each be bonded to each other to form a ring, and the rings may each independently include an oxygen atom, a sulfur atom, a ketone group, an ester bond, or an amide bond.

Examples of the above-described ring include an aromatic or non-aromatic hydrocarbon ring, an aromatic or non-aromatic heterocyclic ring, and a polycyclic fused ring formed by a combination of two or more of these rings. Examples of the ring include a 3- to 10-membered ring, and the ring is preferably a 4- to 8-membered ring and more preferably a 5- or 6-membered ring.

Examples of the group formed by the bonding of any two or more of R_{1c}, ... , or R_{5c}, R_{6c} and R_{7c}, and Rₓ and R_{y} include an alkylene group such as a butylene group and a pentylene group. A methylene group in this alkylene group may be substituted with a heteroatom such as an oxygen atom.

As the group formed by the bonding of R_{5c} and R_{6c}, and R_{5c} and Rₓ, a single bond or an alkylene group is preferable. Examples of the alkylene group include a methylene group and an ethylene group.

Next, the cation (ZaI-4b) will be described.

The cation (ZaI-4b) is a cation represented by General Formula (ZaI-4b).

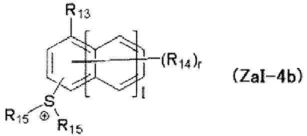

In General Formula (ZaI-4b),
1 represents an integer of 0 to 2.
r represents an integer of 0 to 8.
R₁₃ represents a hydrogen atom, a fluorine atom, a hydroxyl group, an alkyl group, an alkoxy group, an alkoxycarbonyl group, or a group having a cycloalkyl group (which may be the cycloalkyl group itself or a group including the cycloalkyl group in a part thereof). These groups may have a substituent.
R₁₄ represents a hydroxyl group, an alkyl group, an alkoxy group, an alkoxycarbonyl group, an alkylcarbonyl group, an alkylsulfonyl group, a cycloalkylsulfonyl group, or a group having a cycloalkyl group (which may be the cycloalkyl group itself or a group including the cycloalkyl group in a part thereof). These groups may have a substituent. In a case where R₁₄'s are present in a plural number, R₁₄'s each independently represent the above-described group such as a hydroxyl group.
R₁₅'s each independently represent an alkyl group, a cycloalkyl group, or a naphthyl group. These groups may have a substituent. Two R₁₅'s may be bonded to each other to form a ring. In a case where two R₁₅'s are bonded to each other to form a ring, the ring skeleton may include a heteroatom such as an oxygen atom and a nitrogen atom. In one aspect, it is preferable that two R₁₅'s are alkylene groups and are bonded to each other to form a ring structure.

In General Formula (ZaI-4b), the alkyl group of R₁₃, R₁₄, and R₁₅ is linear or branched. The number of carbon atoms in the alkyl group is preferably 1 to 10. The alkyl group is more preferably a methyl group, an ethyl group, an n-butyl group, a t-butyl group, or the like.

Next, General Formula (ZaII) will be described.

In General Formula (ZaII), R²⁰⁴ and R²⁰⁵ each independently represent an aryl group, an alkyl group, or a cycloalkyl group.

The aryl group of R²⁰⁴ and R²⁰⁵ is preferably a phenyl group or a naphthyl group, and more preferably a phenyl group. The aryl group of R²⁰⁴ and R²⁰⁵ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of R²⁰⁴ and R²⁰⁵ are preferably a linear alkyl group having 1 to 10 carbon atoms or a branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group).

The aryl group, the alkyl group, and the cycloalkyl group of R²⁰⁴ and R²⁰⁵ may each independently have a substituent. Examples of the substituent which may be included in each of the aryl group, the alkyl group, and the cycloalkyl group of R²⁰⁴ and R²⁰⁵ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

The anionic group of A₃⁻ is a group having an anionic atom and is not particularly limited. However, a group selected from the group consisting of groups represented by General Formulae (B-1) to (B-14) is preferable.

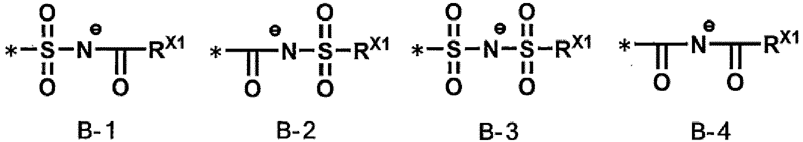

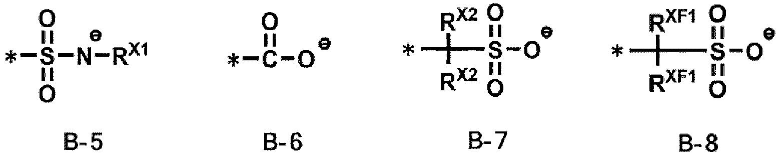

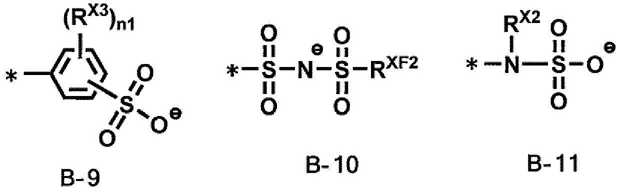

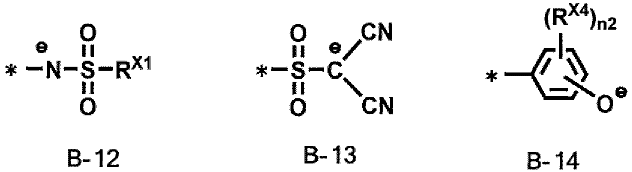

In Formulae (B-1) to (B-14), ^{∗} represents a bonding position.

In Formulae (B-1) to (B-5) and (B-12), R^{X1}'s each independently represent a monovalent organic group.

In Formulae (B-7) and (B-11), R^{X2}'s each independently represent a hydrogen atom or a substituent other than a fluorine atom and a perfluoroalkyl group. Two R^{X2}'s in Formula (B-7) may be the same or different from each other.

In General Formula (B-8), R^{XF1} represents a hydrogen atom, a fluorine atom, or a perfluoroalkyl group, where at least one of a plurality of R^{XF1}'s represents a fluorine atom or a perfluoroalkyl group. Two R^{XF1}'s in Formula (B-8) may be the same or different from each other.

In General Formula (B-9), R^{X3} represents a hydrogen atom, a halogen atom, or a monovalent organic group, n1 represents an integer of 0 to 4, and in a case where n1 represents an integer of 2 to 4, a plurality of R^{X3}'s may be the same or different from each other.

In General Formula (B-10), R^{XF2} represents a fluorine atom or a perfluoroalkyl group.

In General Formula (B-14), R^{X4} represents a hydrogen atom, a halogen atom, or a monovalent organic group, n2 represents an integer of 0 to 4, and in a case where n2 represents an integer of 2 to 4, a plurality of R^{X4}'s may be the same or different from each other.

In General Formulae (B-1) to (B-5) and (B-12), R^{X1}'s each independently represent a monovalent organic group.

As R^{X1}, an alkyl group (may be linear or branched; the number of carbon atoms is preferably 1 to 15), a cycloalkyl group (may be monocyclic or polycyclic; the number of carbon atoms is preferably 3 to 20), or an aryl group (may be monocyclic or polycyclic; the number of carbon atoms is preferably 6 to 20) is preferable.

In General Formula (B-5), an atom directly bonded to N⁻ in R^{X1} is preferably neither a carbon atom in -CO- nor a sulfur atom in -SO₂-.

The cycloalkyl group in R^{X1} may be monocyclic or polycyclic.

Examples of the cycloalkyl group in R^{X1} include a norbornyl group and an adamantyl group.

A substituent which may be included in the cycloalkyl group in R^{X1} is not particularly limited, and examples thereof include the above-described substituent T, and an alkyl group (may be linear or branched; preferably having 1 to 5 carbon atoms) is preferable.

One or more of carbon atoms which are ring member atoms of the cycloalkyl group in R^{X1} may be replaced with a carbonyl carbon atom.

The number of carbon atoms in the alkyl group in R^{X1} is preferably 1 to 10 and more preferably 1 to 5.

A substituent which may be included in the alkyl group in R^{X1} is not particularly limited, and examples thereof include the above-described substituent T, and a cycloalkyl group, a fluorine atom, or a cyano group is preferable.

Examples of the cycloalkyl group as the substituent include those of the cycloalkyl group described in a case where R^{X1} is the cycloalkyl group.

In a case where the alkyl group in R^{X1} has a fluorine atom as the substituent, the above-described alkyl group may be a perfluoroalkyl group.

In addition, one or more of -CH₂-'s in the alkyl group in R^{X1} may be replaced with a carbonyl group.

The aryl group in R^{X1} is preferably a benzene ring group.

A substituent which may be included in the aryl group in R^{X1} is not particularly limited, and examples thereof include the above-described substituent T, and an alkyl group, a fluorine atom, or a cyano group is preferable. Examples of the alkyl group as the substituent include those of the alkyl group described in a case where R^{X1} is the cycloalkyl group.

In General Formulae (B-7) and (B-11), R^{X2}'s each independently represent a hydrogen atom or a substituent other than a fluorine atom and a perfluoroalkyl group. Two R^{X2}'s in Formula (B-7) may be the same or different from each other.

As the substituent other than a fluorine atom and a perfluoroalkyl group, which is represented by R^{X2}, an alkyl group other than the perfluoroalkyl group or a cycloalkyl group is preferable.

Examples of the above-described alkyl group include alkyl groups of the alkyl group in R^{X1}, excluding a perfluoroalkyl group. In addition, it is preferable that the above-described alkyl group has no fluorine atom.

Examples of the above-described cycloalkyl group include the cycloalkyl group in R^{X1}. In addition, it is preferable that the above-described cycloalkyl group has no fluorine atom.

In General Formula (B-8), R^{XF1} represents a hydrogen atom, a fluorine atom, or a perfluoroalkyl group. However, at least one of a plurality of R^{XF1}'s represents a fluorine atom or a perfluoroalkyl group. Two R^{XF1}'s in Formula (B-8) may be the same or different from each other.

The number of carbon atoms in the perfluoroalkyl group represented by R^{XF1} is preferably 1 to 15, more preferably 1 to 10, and still more preferably 1 to 6.

In General Formula (B-9), R^{X3} represents a hydrogen atom, a halogen atom, or a monovalent organic group. Examples of the halogen atom as R^{X3} include a fluorine atom, a chlorine atom, a bromine atom, and an iodine atom, and among these, a fluorine atom is preferable.

The monovalent organic group as R^{X3} is the same as the monovalent organic group described as R^{X1}.

n1 represents an integer of 0 to 4.

n1 is preferably an integer of 0 to 2, and more preferably 0 or 1. In a case where n1 represents an integer of 2 to 4, a plurality of R^{X3}'s may be the same or different from each other.

In General Formula (B-10), R^{XF2} represents a fluorine atom or a perfluoroalkyl group.

The number of carbon atoms in the perfluoroalkyl group represented by R^{XF2} is preferably 1 to 15, more preferably 1 to 10, and still more preferably 1 to 6.

In General Formula (B-14), R^{X4} represents a hydrogen atom, a halogen atom, or a monovalent organic group. Examples of the halogen atom as R^{X4} include a fluorine atom, a chlorine atom, a bromine atom, and an iodine atom, and among these, a fluorine atom is preferable.

The monovalent organic group as R^{X4} is the same as the monovalent organic group described as R^{X1}.

n2 represents an integer of 0 to 4.

n2 is preferably an integer of 0 to 2, and more preferably 0 or 1. In a case where n2 represents an integer of 2 to 4, a plurality of R^{X4}'s may be the same or different from each other.

It is preferable that A₃⁻ in the compound represented by General Formula (6) described above is a group selected from the group consisting of the groups represented by General Formulae (B-6), (B-7), (B-8), (B-9), and (B-14).

As a preferred aspect, it is preferable that the above-described ionic compound (A) and the above-described resin (B) are the same compound. That is, in this aspect, the above-described resin (B) has an ionic group, and the ionic group thereof includes those described in the above-described ionic compound (A).

In the above-described aspect, as a preferred aspect, it is preferable that the monovalent organic group as Ra in the above-described compound represented by General Formula (6) includes a main chain structure of the resin.

In addition, in a case where the above-described ionic compound (A) and the above-described resin (B) are the same compound, the resist composition according to the embodiment of the present invention may further include the ionic compound (A).

The ionic compound (A) is preferably a compound which generates an acid by irradiation with X-rays, electron beam, or extreme ultraviolet rays.

An acid dissociation constant (pKa) of the acid generated by irradiation with X-rays, electron beam, or extreme ultraviolet rays is not particularly limited, but is preferably -15.0 or more.

In addition, the acid dissociation constant (pKa) of the acid generated by irradiation with X-rays, electron beam, or extreme ultraviolet rays is not particularly limited, but is preferably 6.5 or less.

Examples of the ionic compound (A) will be shown below, but the present invention is not limited thereto.

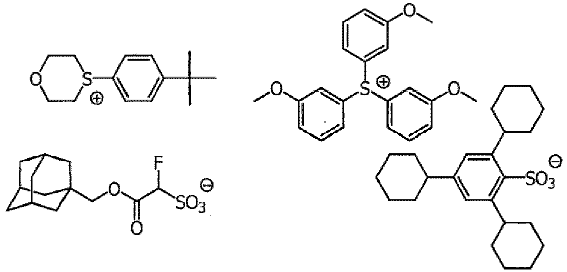

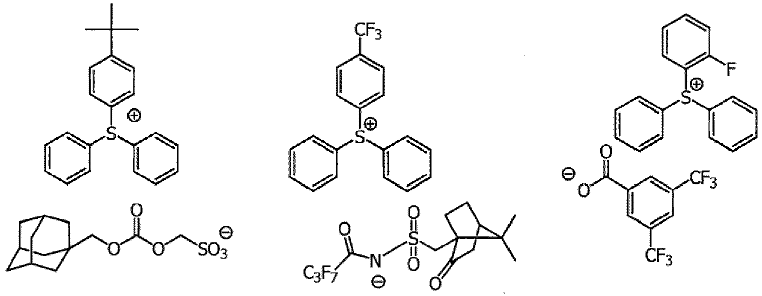

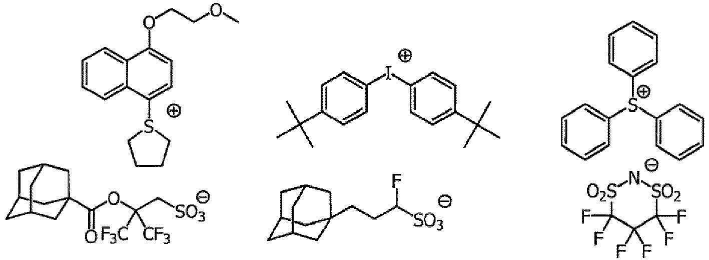

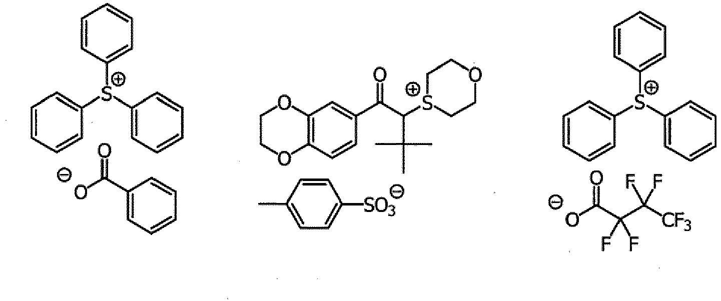

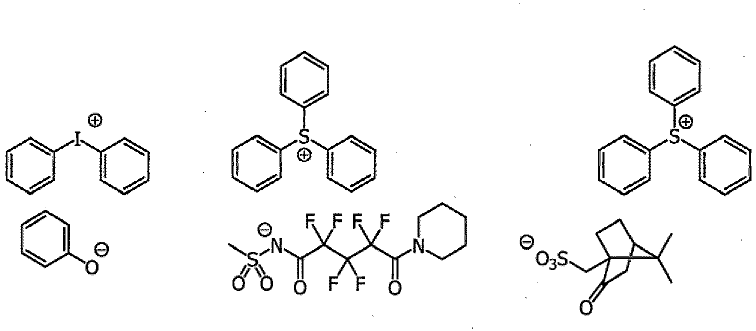

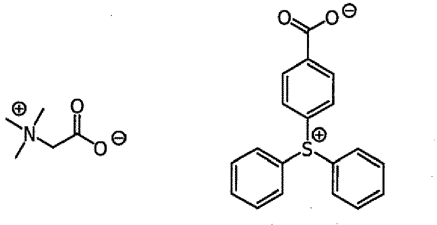

A content of the ionic compound (A) in the resist composition is not particularly limited, but from the viewpoint that the effects of the present invention are more excellent, the content is preferably 0.1% to 30% by mass, more preferably 0.5% to 25% by mass, and still more preferably 3.0% to 21.5% by mass with respect to the total solid content of the composition.

The ionic compound (A) may be used alone or in combination of two or more kinds thereof.

<(B) Resin that Has Repeating Unit (b1) Having Interactive Group which Interacts with Ionic group in Ionic compound and that Main Chain is Decomposed by Irradiation with X-rays, Electron beam, or Extreme ultraviolet rays>

The resist composition contains (B) a resin (hereinafter, also referred to as a "resin (B)") that has a repeating unit (b1) having an interactive group which interacts with an ionic group in the ionic compound and that a main chain is decomposed by an irradiation with X-rays, electron beam, or extreme ultraviolet rays.

The resin (B) is a resin in which the main chain is decomposed by irradiation with X-rays, electron beam, or extreme ultraviolet rays, and specifically, the main chain is cleaved by irradiation with X-rays, electron beam, or extreme ultraviolet rays so as to be decomposed and have a low molecular weight.

The resin (B) preferably has a repeating unit represented by General Formula (1), and as a result, it is possible to suitably obtain the resin in which the main chain is decomposed by irradiation with X-rays, electron beam, or extreme ultraviolet rays.

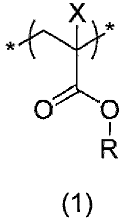

In General Formula (1),
X represents a halogen atom or a fluoroalkyl group, and
R represents a hydrogen atom or a monovalent organic group.

The halogen atom as X is not particularly limited, and examples thereof include a fluorine atom, a chlorine atom, a bromine atom, and an iodine atom. As the halogen atom, a fluorine atom, a chlorine atom, or a bromine atom is preferable, a fluorine atom or a chlorine atom is more preferable, and a chlorine atom is particularly preferable.

The fluoroalkyl group as X is an alkyl group substituted with a fluorine atom, and examples thereof include a linear or branched alkyl group having 1 to 10 carbon atoms, which is substituted with a fluorine atom. As the fluoroalkyl group, a trifluoromethyl group is preferable.

The monovalent organic group as R is not particularly limited, and specific examples thereof include an alkyl group, a cycloalkyl group, an aryl group, and an aralkyl group.

The alkyl group may be linear or branched, and the number of carbon atoms is preferably 1 to 20 and more preferably 1 to 15.

The cycloalkyl group may be monocyclic or polycyclic, and the number of carbon atoms is preferably 3 to 20 and more preferably 5 to 15. The cycloalkyl group may have a heteroatom such as an oxygen atom as a ring member.

The aryl group preferably has 6 to 20 carbon atoms and more preferably has 6 to 15 carbon atoms.

The aralkyl group preferably has 7 to 21 carbon atoms and more preferably has 7 to 16 carbon atoms.

The above-described alkyl group, cycloalkyl group, aryl group, and aralkyl group may further have a substituent. The further substituent is not particularly limited, but the above-described substituent T is preferable and an alkyl group, a halogen atom, or a carboxyl group is more preferable.

In a case where the further substituent which may be included in the above-described alkyl group, cycloalkyl group, aryl group, and aralkyl group corresponds to an interactive group described later, the above-described repeating unit represented by General Formula (1) corresponds to the repeating unit (b1) described later.

A content of the repeating unit represented by General Formula (1) in the resin (B) is preferably 10 mol% to 50 mol%, more preferably 20 mol% to 50 mol%, and particularly preferably 25 mol% to 50 mol% with respect to all repeating units of the resin (B).

The resin (B) may use one kind of the repeating unit represented by General Formula (1) alone or may use two or more kinds thereof.

Examples of the repeating unit represented by General Formula (1) will be shown below, but the present invention is not limited thereto.

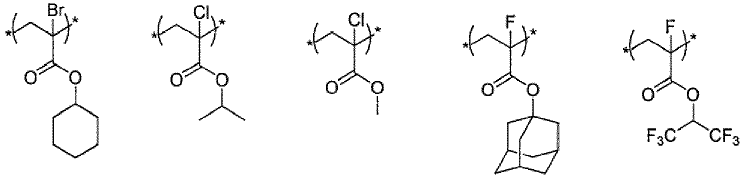

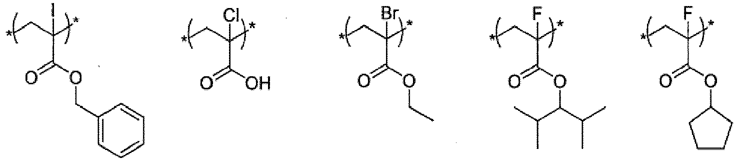

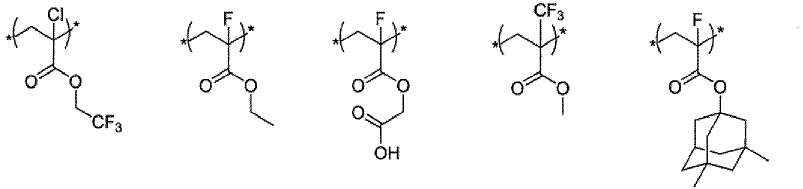

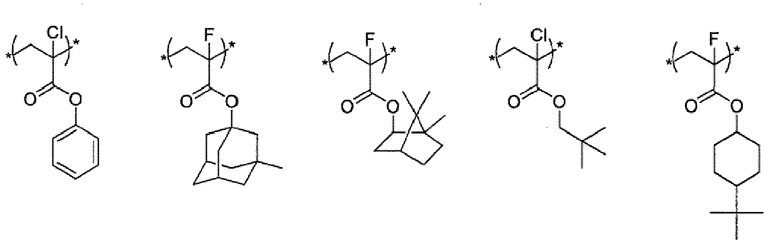

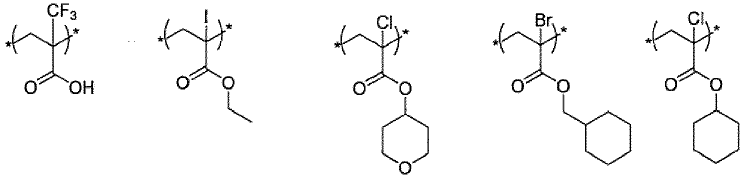

### (Repeating Unit (b1) having Interactive group which Interacts with Ionic group in Ionic compound)

The resin (B) has a repeating unit (b1) having an interactive group which interacts with the ionic group in the above-described ionic compound.

The above-described interactive group is a group which interacts with the ionic group in the above-described ionic compound. Specifically, as described above, it is considered that the interactive group interacts with the above-described ionic group to form an association structure in a form close to a salt.

As the above-described interactive group, the resin (B) preferably has at least one selected from the group consisting of a hydroxyl group, a carboxyl group, a carbonate group, a carbonyl group, an amino group, an amide group, a thiol group, an alkoxycarbonyl group, an alkyloxysulfonyl group, a sulfo group, a sulfonyl group, and an alkylsulfonyl group, and more preferably has at least one selected from the group consisting of a hydroxyl group, an amino group, an amide group, and a thiol group.

Examples of the amino group include -NH₂ and -NHR₁ (R₁ represents an alkyl group having 1 to 5 carbon atoms).

Examples of the amide group include -C(=O)-NHR₂ (R₂ represents a hydrogen atom or an alkyl group having 1 to 5 carbon atoms).

The thiol group represents a group represented by -SH.

An alkyl group in the alkoxycarbonyl group may be linear or branched, and the number of carbon atoms is preferably 1 to 5 and more preferably 1 to 3.

An alkyl group in the alkyloxysulfonyl group may be linear or branched, and the number of carbon atoms is preferably 1 to 5 and more preferably 1 to 3.

An alkyl group in the alkylsulfonyl group may be linear or branched, and the number of carbon atoms is preferably 1 to 5 and more preferably 1 to 3.

Preferred examples of a preferred aspect of the above-described interactive group include a group having proton-donating properties. The proton-donating properties are expressed by having a liberated hydrogen atom.

In addition, preferred examples of a preferred aspect of the above-described interactive group include a group having proton-accepting properties. The proton-accepting properties are expressed by having a substituent which has a lone pair having a relatively high electronegativity, such as a fluorine atom, a nitrogen, and an oxygen atom.

The above-described repeating unit (b1) is preferably a repeating unit represented by General Formula (3).

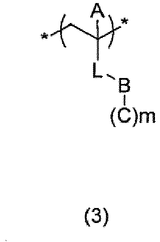

In General Formula (3),
A represents a hydrogen atom, a halogen atom, or an alkyl group,
L represents a divalent linking group,
B represents a single bond or an (m+1)-valent linking group,
C represents the interactive group,
m represents an integer of 1 or more, and
in a case where m is an integer of 2 or more, a plurality of C's may be the same or different from each other.

The halogen atom as A is not particularly limited, and examples thereof include a fluorine atom, a chlorine atom, a bromine atom, and an iodine atom.

The alkyl group as A is not particularly limited and may be linear or branched, and the number of carbon atoms is preferably 1 to 5 and more preferably 1 or 2.

The divalent linking group as L is not particularly limited, and represents an alkylene group, a cycloalkylene group, an aromatic group, -CO-, -COO-, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and the above-described substituent T is preferable.

B represents a single bond or an (m+1)-valent linking group.

Examples of the (m+1)-valent linking group of B include a group obtained by removing (m-1) hydrogen atoms from the above-described divalent linking group as L.

C represents the above-described interactive group. The interactive group of C is not particularly limited as long as it is a group which interacts with the ionic group in the ionic compound, and at least one selected from the group consisting of a hydroxyl group, a carboxyl group, a carbonate group, a carbonyl group, an amino group, an amide group, a thiol group, an alkoxycarbonyl group, an alkyloxysulfonyl group, a sulfo group, a sulfonyl group, and an alkylsulfonyl group is preferable, and at least one selected from the group consisting of a hydroxyl group, an amino group, an amide group, and a thiol group is more preferable.

Examples of the amino group include -NH₂ and -NHR₁ (R₁ represents an alkyl group having 1 to 5 carbon atoms).

Examples of the amide group include -C(=O)-NHR₂ (R₂ represents a hydrogen atom or an alkyl group having 1 to 5 carbon atoms).

The thiol group represents a group represented by -SH.

An alkyl group in the alkoxycarbonyl group may be linear or branched, and the number of carbon atoms is preferably 1 to 5 and more preferably 1 to 3.

An alkyl group in the alkyloxysulfonyl group may be linear or branched, and the number of carbon atoms is preferably 1 to 5 and more preferably 1 to 3.

An alkyl group in the alkylsulfonyl group may be linear or branched, and the number of carbon atoms is preferably 1 to 5 and more preferably 1 to 3.

m represents an integer of 1 or more. An upper limit value of m is not particularly limited, but is preferably 5 or less.

m is more preferably an integer of 1 or 2.

In a case where m represents an integer of 2 or more, a plurality of C's may be the same or different from each other.

The above-described repeating unit (b1) is preferably a repeating unit represented by General Formula (2).

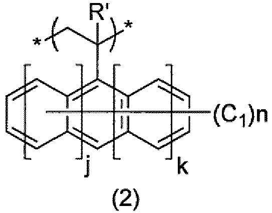

In General Formula (2),
R' represents a hydrogen atom or an alkyl group,
C₁ represents the interactive group,
j represents 0 or 1,
k represents 0 or 1,
n represents an integer of 1 to 9, and
in a case where n is an integer of 2 to 9, a plurality of C₁'s may be the same or different from each other.

The alkyl group as R' is not particularly limited and may be linear or branched, and the number of carbon atoms is preferably 1 to 5 and more preferably 1 or 2.

The above-described interactive group as C₁ is the same as the above-described interactive group as C.

n is preferably an integer of 1 to 3 and more preferably 1 or 2.

In a case where n represents an integer of 2 to 9, a plurality of C₁'s may be the same or different from each other.

A content of the repeating unit (b1) in the resin (B) is preferably 1 mol% to 50 mol%, more preferably 1 mol% to 40 mol%, and particularly preferably 1 mol% to 30 mol% with respect to all repeating units of the resin (B).

As a preferred aspect, it is preferable that the content of the repeating unit (b1) in the resin (B) is 20 mol% or less with respect to all repeating units of the resin (B).

The resin (B) may use one kind of the repeating unit (b1) alone or may use two or more kinds thereof.

Examples of a repeating unit corresponding to the repeating unit (b1) will be shown below, but the present invention is not limited thereto.

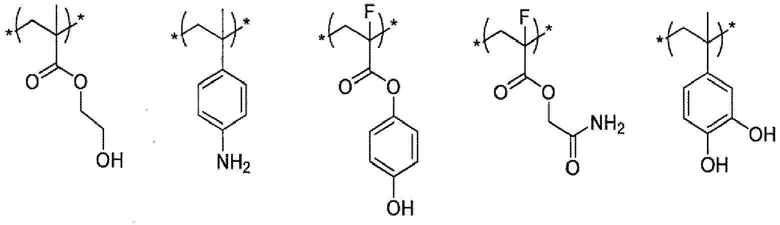

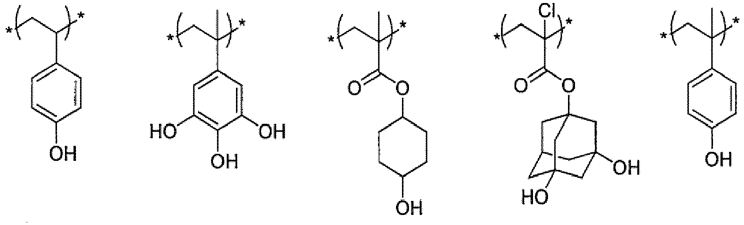

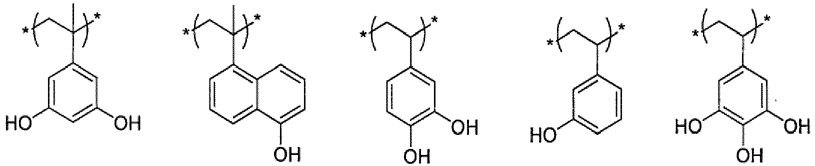

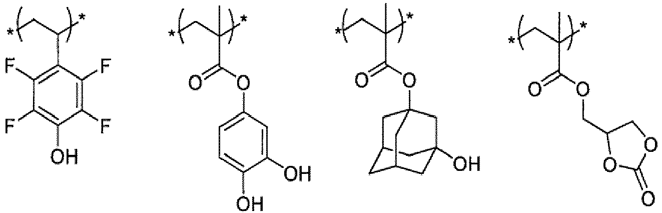

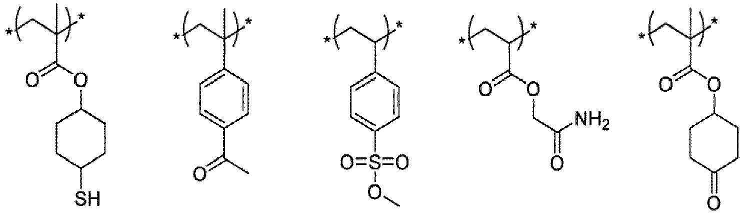

### (Other Repeating Units)

The resin (B) may include a repeating unit other than the above-described repeating unit represented by General Formula (1) and the above-described repeating unit (b1).

As a preferred aspect, it is preferable that the above-described ionic compound (A) and the above-described resin (B) are the same compound. That is, in this aspect, the resin (B) has an ionic group, and the ionic group thereof includes those described in the above-described ionic compound (A).

In the above-described aspect, the resin (B) may have at least one repeating unit selected from the group consisting of a repeating unit represented by General Formula (4) and a repeating unit represented by General Formula (5).

(At Least One Selected from Group Consisting of Repeating Unit Represented by General Formula (4) and Repeating Unit Represented by General Formula (5))

### <Repeating Unit Represented by General Formula (4)>

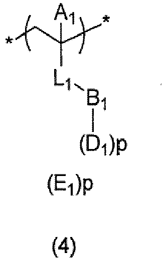

In General Formula (4),
A₁ represents a hydrogen atom, a halogen atom, or an alkyl group,
L₁ represents a single bond or a divalent linking group,
B₁ represents a single bond or a (p+1)-valent linking group,
D₁ represents an anionic group,
E₁ represents a cation,
p represents an integer of 1 or 2, and
in a case where p is an integer of 2, a plurality of D₁'s and a plurality of E₁'s may be the same or different from each other.

The halogen atom as A₁ is not particularly limited, and examples thereof include a fluorine atom, a chlorine atom, a bromine atom, and an iodine atom.

The alkyl group as A₁ is not particularly limited and may be linear or branched, and the number of carbon atoms is preferably 1 to 5 and more preferably 1 or 2.

The divalent linking group as L₁ is not particularly limited, and represents an alkylene group, a cycloalkylene group, an aromatic group, -CO-, -COO-, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and the above-described substituent T is preferable.

B₁ represents a single bond or a (p+1)-valent linking group.

Examples of the (p+1)-valent linking group of B₁ include a group obtained by removing (p-1) hydrogen atoms from the above-described divalent linking group as L₁.

D₁ represents an anionic group.

The anionic group of D₁ is a group having an anionic atom and is not particularly limited. However, a group selected from the group consisting of the groups represented by General Formulae (B-1) to (B-14) described above is preferable.

It is preferable that the anionic group of D₁ is a group selected from the group consisting of the groups represented by General Formulae (B-6), (B-7), (B-8), (B-9), and (B-14) described above.

E₁ represents a cation.

(E₁)p means representing p pieces of cations E₁.

The cation as E₁ is preferably an organic cation which is decomposed by irradiation with X-rays, electron beam, or extreme ultraviolet rays, and the above-described organic cation (cation (ZaI)) represented by General Formula (ZaI) or the above-described organic cation (cation (ZaII)) represented by General Formula (ZaII) is preferable.

p represents an integer of 1 or 2.

In a case where p represents an integer of 2, a plurality of D₁'s and a plurality of E₁'s may be the same or different from each other.

A content of the repeating unit represented by General Formula (4) in the resin (B) is preferably 1 mol% to 20 mol%, more preferably 1 mol% to 15 mol%, and particularly preferably 1 mol% to 10 mol% with respect to all repeating units of the resin (B).

The resin (B) may use one kind of the repeating unit represented by General Formula (4) alone or may use two or more kinds thereof.

Examples of the repeating unit represented by General Formula (4) will be shown below, but the present invention is not limited thereto.

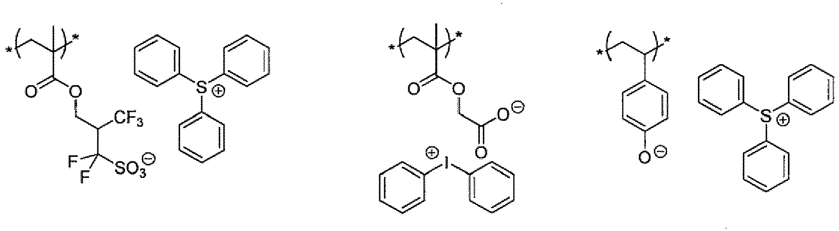

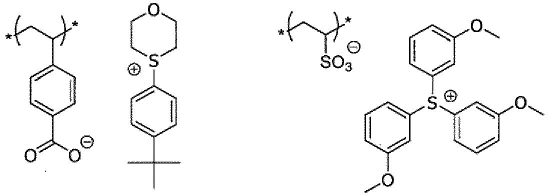

### <Repeating Unit Represented by General Formula (5)>

As the at least one repeating unit selected from the group consisting of a repeating unit represented by General Formula (4) and a repeating unit represented by General Formula (5), the resin (B) may have a repeating unit represented by General Formula (5).

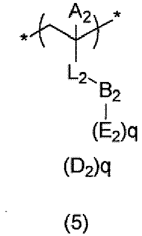

In General Formula (5),
A2 represents a hydrogen atom, a halogen atom, or an alkyl group,
L2 represents a divalent linking group,
B₂ represents a single bond or a (q+1)-valent linking group,
D₂ represents an anion,
E₂ represents a cationic group,
q represents an integer of 1 or 2, and
in a case where q is an integer of 2, a plurality of D₂'s and a plurality of E₂'s each may be the same or different from each other.

The halogen atom as A₂ is not particularly limited, and examples thereof include a fluorine atom, a chlorine atom, a bromine atom, and an iodine atom.

The alkyl group as A₂ is not particularly limited and may be linear or branched, and the number of carbon atoms is preferably 1 to 5 and more preferably 1 or 2.

The divalent linking group as L₂ is not particularly limited, and represents an alkylene group, a cycloalkylene group, an aromatic group, -CO-, -COO-, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and the above-described substituent T is preferable.

B2 represents a single bond or a (q+1)-valent linking group.

Examples of the (q+1)-valent linking group of B2 include a group obtained by removing (q-1) hydrogen atoms from the above-described divalent linking group as L2.

D₂ represents an anion.

(D₂)q means representing q pieces of anions D₂.

The anion of D₂ is not particularly limited, but an anion represented by General Formula (DA) is preferable.

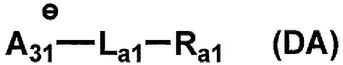

In General Formula (DA),
A₃₁⁻ represents an anionic group,
Rₐ₁ represents a hydrogen atom or a monovalent organic group, and
Lₐ₁ represents a single bond or a divalent linking group.

A₃₁⁻ represents an anionic group. The anionic group of A₃₁⁻ is a group having an anionic atom and is not particularly limited. However, a group selected from the group consisting of the groups represented by General Formulae (B-1) to (B-14) described above is preferable.

The monovalent organic group of Rₐ₁ is not particularly limited, and generally, the number of carbon atoms is 1 to 30, preferably 1 to 20.

Rₐ₁ is preferably an alkyl group, a cycloalkyl group, or an aryl group.

The alkyl group may be linear or branched, and an alkyl group having 1 to 20 carbon atoms is preferable, an alkyl group having 1 to 15 carbon atoms is more preferable, and an alkyl group having 1 to 10 carbon atoms is still more preferable.

The cycloalkyl group may be monocyclic or polycyclic, and a cycloalkyl group having 3 to 20 carbon atoms is preferable, a cycloalkyl group having 3 to 15 carbon atoms is more preferable, and a cycloalkyl group having 3 to 10 carbon atoms is still more preferable.

The aryl group may be monocyclic or polycyclic, and an aryl group having 6 to 20 carbon atoms is preferable, an aryl group having 6 to 15 carbon atoms is more preferable, and an aryl group having 6 to 10 carbon atoms is still more preferable.

The cycloalkyl group may include a heteroatom as a ring member atom. The heteroatom is not particularly limited, and examples thereof include a nitrogen atom and an oxygen atom.

In addition the cycloalkyl group may include a carbonyl bond (>C=O) as a ring member atom.

The above-described alkyl group, cycloalkyl group, and aryl group may further have a substituent. The further substituent is not particularly limited, and the above-described substituent T is preferable.

The divalent linking group as Lₐ₁ is not particularly limited, and represents an alkylene group, a cycloalkylene group, an aromatic group, -O-, -CO-, -COO-, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and examples thereof include the above-described substituent T, and a halogen atom is preferable.

A₃₁⁻ and Ra₁ may be bonded to each other to form a ring.

E₂ represents a cationic group. The cationic group as E₂ is a group having a cationic atom, preferably an organic cationic group which is decomposed by irradiation with X-rays, electron beam, or extreme ultraviolet rays, and an organic cationic group represented by General Formula (ZBI) or an organic cationic group represented by General Formula (ZBII) is preferable.

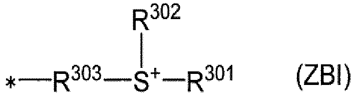

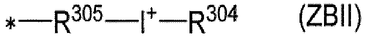

In General Formula (ZBI),
R³⁰¹ and R³⁰² each independently represent an organic group.

The number of carbon atoms in the organic group of R³⁰¹ and R³⁰² is usually 1 to 30, and preferably 1 to 20.

R³⁰³ represents a divalent linking group.

In addition, two of R³⁰¹ to R³⁰³ may be bonded to each other to form a ring structure, and the ring structure may include an oxygen atom, a sulfur atom, an ester group, an amide group, or a carbonyl group in the ring. Examples of the group formed by the bonding of two of R³⁰¹ to R³⁰³ include an alkylene group (for example, a butylene group and a pentylene group) and -CH₂-CH₂-O-CH₂-CH₂-.

The organic group as R³⁰¹ and R³⁰² is not particularly limited, and an alkyl group, a cycloalkyl group, or an aryl group is preferable.

The aryl group is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue.

The alkyl group or the cycloalkyl group is preferably a linear alkyl group having 1 to 15 carbon atoms, a branched alkyl group having 3 to 15 carbon atoms, or a cycloalkyl group having 3 to 15 carbon atoms, and examples thereof include a methyl group, an ethyl group, a propyl group, an n-butyl group, a sec-butyl group, a t-butyl group, a cyclopropyl group, a cyclobutyl group, and a cyclohexyl group.

Examples of substituents which may be included in each of the aryl group, the alkyl group, and the cycloalkyl group of R³⁰¹ and R³⁰² include an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkylalkoxy group (for example, having 1 to 15 carbon atoms), a halogen atom, a hydroxyl group, and a phenylthio group.

The divalent linking group as R³⁰³ is not particularly limited, and represents an alkylene group, a cycloalkylene group, an aromatic group, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and the above-described substituent T is preferable.

In General Formula (ZBII),
R³⁰⁴ represents an aryl group, an alkyl group, or a cycloalkyl group.
R³⁰⁵ represents a divalent linking group.

The aryl group of R³⁰⁴ is preferably a phenyl group or a naphthyl group, and more preferably a phenyl group. The aryl group of R³⁰⁴ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of R³⁰⁴ are preferably a linear alkyl group having 1 to 10 carbon atoms or a branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group).

The aryl group, the alkyl group, and the cycloalkyl group of R³⁰⁴ may each independently have a substituent. Examples of the substituent which may be included in each of the aryl group, the alkyl group, and the cycloalkyl group of R³⁰⁴ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

The divalent linking group as R³⁰⁵ is not particularly limited, and represents an alkylene group, a cycloalkylene group, an aromatic group, or a group of a combination of two or more of these groups.

The alkylene group may be linear or branched, and the number of carbon atoms is preferably 1 to 20 and more preferably 1 to 10.

The cycloalkylene group may be monocyclic or polycyclic, and the number of carbon atoms is preferably 3 to 20 and more preferably 3 to 10.

The aromatic group is a divalent aromatic group, and an aromatic group having 6 to 20 carbon atoms is preferable and an aromatic group having 6 to 15 is more preferable.

An aromatic ring constituting the aromatic group is not particularly limited, and examples thereof include an aromatic ring having 6 to 20 carbon atoms. Specific examples thereof include a benzene ring, a naphthalene ring, an anthracene ring, and a thiophene ring. A benzene ring or a naphthalene ring is preferable, and a benzene ring is more preferable.

The alkylene group, cycloalkylene group, and aromatic group may further have a substituent. The further substituent is not particularly limited, and the above-described substituent T is preferable.

q represents an integer of 1 or 2.

In a case where q represents an integer of 2, a plurality of D₂'s and a plurality of E₂'s may be the same or different from each other.

A content of the repeating unit represented by General Formula (5) in the resin (B) is preferably 1 mol% to 20 mol%, more preferably 1 mol% to 15 mol%, and particularly preferably 1 mol% to 10 mol% with respect to all repeating units of the resin (B).

The resin (B) may use one kind of the repeating unit represented by General Formula (5) alone or may use two or more kinds thereof.

Examples of the repeating unit represented by General Formula (5) will be shown below, but the present invention is not limited thereto.

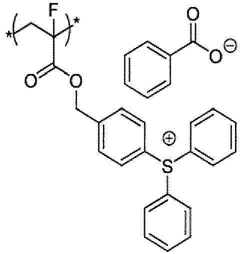

It is preferable that the above-described resin (B) has the above-described repeating unit represented by General Formula (3) as the above-described repeating unit (b1), and has at least one repeating unit selected from the group consisting of the above-described repeating unit represented by General Formula (4) and the above-described repeating unit represented by General Formula (5).

In addition, as a preferred aspect, the above-described resin (B) has the above-described repeating unit represented by General Formula (2) as the above-described repeating unit (b1), and has at least one repeating unit selected from the group consisting of the above-described repeating unit represented by General Formula (4) and the above-described repeating unit represented by General Formula (5).

In a case where the above-described ionic compound (A) and the above-described resin (B) are the same compound, the resist composition according to the embodiment of the present invention may further include the resin (B).

### (Repeating Unit Represented by General Formula (7))

The resin (B) may have a repeating unit represented by General Formula (7) (excluding a repeating unit corresponding to the repeating unit represented by General Formula (2)).

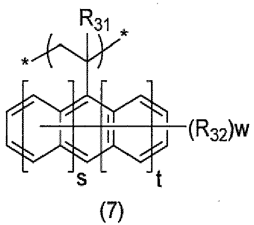

In General Formula (7),
R31 represents a hydrogen atom or an alkyl group,
R32 represents a monovalent organic group,
s represents 0 or 1,
t represents 0 or 1,
w represents an integer of 0 to 9, and
in a case where w is an integer of 2 to 9, a plurality of R₃₂'s may be the same or different from each other.

The alkyl group as R₃₁ is not particularly limited and may be linear or branched, and the number of carbon atoms is preferably 1 to 5 and more preferably 1 or 2.

The monovalent organic group as R₃₂ is the same as the monovalent organic group described as R^{X1}.

w is preferably an integer of 1 to 3 and more preferably 1 or 2.

In a case where w represents an integer of 2 to 9, a plurality of R₃₂'s may be the same or different from each other.

A content of the repeating unit represented by General Formula (7) in the resin (B) is preferably 1 mol% to 50 mol%, more preferably 20 mol% to 50 mol%, and particularly preferably 30 mol% to 50 mol% with respect to all repeating units of the resin (B).

The resin (B) may use one kind of the repeating unit represented by General Formula (7) alone or may use two or more kinds thereof.

### (Repeating Unit having Acid-decomposable Group)

The resin (B) may further include a repeating unit having an acid-decomposable group.

The acid-decomposable group preferably has a structure in which a polar group is protected by a group (leaving group) which is eliminated by the action of acid.

Examples of the polar group include an acidic group (typically, a group which dissociates in a 2.38%-by-mass tetramethylammonium hydroxide aqueous solution), such as a carboxyl group, a phenolic hydroxyl group, a fluorinated alcohol group, a sulfonic acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group; and an alcoholic hydroxyl group.

The alcoholic hydroxyl group is a hydroxyl group bonded to a hydrocarbon group and refers to a hydroxyl group other than a hydroxyl group (phenolic hydroxyl group) directly bonded to an aromatic ring, and an aliphatic alcohol (for example, a hexafluoroisopropanol group and the like) having an α-position substituted with an electron withdrawing group such as a fluorine atom is excluded as the hydroxyl group. The alcoholic hydroxyl group is preferably a hydroxyl group having an acid dissociation constant (pKa) from 12 to 20.

Among those, as the polar group, a carboxyl group, a phenolic hydroxyl group, a fluorinated alcohol group (preferably, a hexafluoroisopropanol group), or a sulfonic acid group is preferable.

Examples of the group (leaving group) that is eliminated by the action of acid include groups represented by Formulae (Y1) to (Y4).

Formula (Y1): -C(Rx₁)(Rx₂)(Rx₃)

Formula (Y2): -C(=O)OC(Rx₁)(Rx₂)(Rx₃)

Formula (Y3): -C(R₃₆)(R₃₇)(OR₃₈)

Formula (Y4): -C(Rn)(H)(Ar)

In Formula (Y1) and Formula (Y2), Rx₁ to Rx₃ each independently represent a (linear or branched) alkyl group, a (monocyclic or polycyclic) cycloalkyl group, or a (monocyclic or polycyclic) aryl group.

Among these, it is preferable that Rx₁ to Rx₃ each independently represent a linear or branched alkyl group, and it is more preferable that Rx₁ to Rx₃ each independently represent a linear alkyl group.

Two of Rx₁ to Rx₃ may be bonded to each other to form a monocycle or a polycycle.

The alkyl group of Rx₁ to Rx₃ is not particularly limited, and examples thereof include an alkyl group having 1 to 20 carbon atoms. Among these, an alkyl group having 1 to 4 carbon atoms, such as a methyl group, an ethyl group, an n-propyl group, an isopropyl group, an n-butyl group, an isobutyl group, and a t-butyl group is preferable.

The cycloalkyl group of Rx₁ to Rx₃ is not particularly limited, and examples thereof include a cycloalkyl group having 3 to 20 carbon atoms. Among these, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of Rx₁ to Rx₃, an aryl group having 6 to 14 carbon atoms is preferable, and examples thereof include a phenyl group, a naphthyl group, and an anthryl group.

The alkyl group, cycloalkyl group, and aryl group may have a substituent.

As a cycloalkyl group formed by the bonding of two of Rx₁ to Rx₃, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of Rx₁ to Rx₃, for example, one of methylene groups constituting the ring may be replaced with a heteroatom such as an oxygen atom, or with a group having a heteroatom, such as a carbonyl group.

The cycloalkyl group formed by the bonding of two of Rx₁ to Rx₃ may have a substituent.

In Formula (Y3), R₃₆ to R₃₈ each independently represent a hydrogen atom or a monovalent organic group. R₃₇ and R₃₈ may be bonded to each other to form a ring. Examples of the monovalent organic group include an alkyl group, a cycloalkyl group, an aryl group, an aralkyl group, and an alkenyl group. It is also preferable that R₃₆ is a hydrogen atom.

In Formula (Y4), Ar represents an aromatic ring group. Rn represents an alkyl group, a cycloalkyl group, or an aryl group. Rn and Ar may be bonded to each other to form a non-aromatic ring. Ar is more preferably an aryl group.

A content of the repeating unit having an acid-decomposable group included in the resin (B) is preferably 10 mol% or less and more preferably 5 mol% or less with repeating unit to all repeating units of the resin (B), and it is still more preferable that the resin (B) is substantially free of the repeating unit having an acid-decomposable group. Here, the fact that the resin (B) is substantially free of the repeating unit having an acid-decomposable group is intended that the content of the repeating unit having an acid-decomposable group is 3 mol% or less with respect to all repeating units of the resin (B).

The resin (B) may include a further repeating unit as long as the effects of the present invention are not impaired.

The resin (B) can be synthesized in accordance with an ordinary method (for example, a radical polymerization).

A weight-average molecular weight of the resin (B) as a value expressed in terms of polystyrene by a GPC method is preferably 1,000 to 200,000, more preferably 10,000 to 100,000, and still more preferably 20,000 to 100,000. In a case of setting the weight-average molecular weight of the resin (B) to 1,000 to 200,000, it is possible to prevent deterioration of dry etching resistance, and it is also possible to prevent deterioration of film-forming properties due to deterioration of developability and an increase in viscosity. In addition, as the weight-average molecular weight of the resin (B) is larger, the change in molecular weight in a case where the main chain is decomposed by irradiation with X-rays, electron beam, or extreme ultraviolet rays is larger, and a good resolution pattern can be obtained.

A dispersity (molecular weight distribution) of the resin (B) is usually 1 to 5, preferably 1 to 3, more preferably 1.2 to 3.0, and still more preferably 1.2 to 2.0. As the dispersity is smaller, resolution and resist shape are excellent, and a side wall of a resist pattern is smoother and roughness is excellent.

In the resist composition, a ratio ((number of moles of interactive group in resin (B))/(number of moles of ionic compound (A))) of the number of moles of the interactive group in the resin (B) to the number of moles of the ionic compound (A) is preferably 1 or more. That is, it is preferable that the number of moles of the interactive group in the resin (B) is larger than the number of moles of the ionic compound (A), or that the number of moles of the ionic compound (A) and the number of moles of the interactive group in the resin (B) are the same.

In the resist composition, a content of the resin (B) is preferably 50% to 99.9% by mass, and more preferably 60% to 99.0% by mass in the total solid content. In addition, the resin (B) may be used alone or in combination of two or more kinds thereof.

### <Solvent>

The resist composition may include a solvent.

The solvent preferably includes at least one of (M1) propylene glycol monoalkyl ether carboxylate (propylene glycol monomethyl ether acetate (PGMEA) and the like) or (M2) at least one selected from the group consisting of propylene glycol monoalkyl ether (propylene glycol monomethyl ether (PGME), propylene glycol monoethyl ether (PGEE), and the like), lactate ester (ethyl lactate and the like), acetate ester, alkoxypropionic acid ester, chain ketone, cyclic ketone (2-heptanone, cyclohexanone, cyclopentanone, and the like), lactone (γ-butyrolactone and the like), and alkylene carbonate (propylene carbonate and the like). The solvent may further include a component other than the components (M1) and (M2).

It is preferable that the solvent includes the component (M1). The solvent is more preferably composed of substantially only the component (M1) or is a mixed solvent of the component (M1) and other components. In the latter case, it is still more preferable that the solvent includes both the component (M1) and the component (M2).

A mass ratio (M1/M2) of the component (M1) to the component (M2) is preferably "100/0" to "0/100", more preferably "100/0" to "15/85", still more preferably "100/0" to "40/60", and particularly preferably "100/0" to "60/40".

As described above, the solvent may further include a component other than the components (M1) and (M2). In this case, a content of the component other than the components (M1) and (M2) is preferably 5% to 30% by mass with respect to the total amount of the solvent.

A content of the solvent in the resist composition is preferably set such that the concentration of solid contents is 0.5% to 30% by mass, and more preferably set such that the concentration of solid contents is 1% to 20% by mass. With this content, the coating property of the resist composition can be further improved.

The solid content means all components excluding the solvent.

The "total solid content" refers to a total mass of components obtained by removing the solvent from the whole composition of the resist composition. In addition, the "solid content" refers to components excluding the solvent as described above, and the components may be, for example, a solid or a liquid at 25°C.

### <Acid Diffusion Control Agent>

The resist composition may further include an acid diffusion control agent. For example, the acid diffusion control agent acts as a quencher which traps an acid generated from the above-described ionic compound (A) and functions to control the phenomenon of acid diffusion in the resist film.

The acid diffusion control agent may be, for example, a basic compound.

In a case where the resist composition includes an acid diffusion control agent, an amount of the acid diffusion control agent used is preferably 0.0001% to 2% by mass and more preferably 0.0005% to 1% by mass with respect to the total solid content of the resist composition.

### <Surfactant>

The resist composition may or may not further contain a surfactant.

The surfactant is preferably a fluorine-based and/or silicon-based surfactant (a fluorine-based surfactant, a silicon-based surfactant, or a surfactant having both a fluorine atom and a silicon atom).

The surfactant may be used alone or in combination of two or more kinds thereof.

In a case where the resist composition contains a surfactant, an amount of the surfactant used is preferably 0.0001% to 2% by mass, and more preferably 0.0005% to 1% by mass with respect to the total solid content of the resist composition.

### [Resist Film]

The present invention also relates to a resist film (also referred to as a "resist film") formed of the resist composition according to the embodiment of the present invention. Such a film is formed, for example, by applying the composition according to the embodiment of the present invention to a support such as a substrate. A thickness of the film is preferably 0.02 to 0.1 µm.

As a method for applying the composition on the substrate, the composition is applied to the substrate by an appropriate coating method such as a spin coating, a roll coating, a flow coating, a dip coating, a spray coating, and a doctor coating. Among these, a spin coating is preferable, and the rotation speed thereof is preferably 1000 to 3000 rotations per minute (rpm). The coating film is prebaked at 60°C to 150°C for 1 to 20 minutes, preferably at 80°C to 120°C for 1 to 10 minutes to form a thin film.

For a material constituting the substrate to be processed and an outermost layer thereof, for example, in a case of a semiconductor wafer, a silicon wafer can be used, and examples of the material forming the outermost layer include Si, SiO₂, SiN, SiON, and TiN, WSi, BPSG, SOG, and an organic antireflection film.

### [Pattern Forming Method]

A procedure of the pattern forming method using the above-described resist composition is not particularly limited, but preferably has the following steps.
Step 1: step of forming a resist film on a substrate by the resist composition
Step 2: step of exposing the resist film with X-rays, electron beam (EB), or extreme ultraviolet rays (EUV light)
Step 3: step of developing the exposed resist film by a developer to form a pattern

Hereinafter, the procedure of each of the above-described steps will be described in detail.

### <Step 1: Resist Film Forming Step>

The step 1 is a step of forming a resist film on a substrate by the resist composition. The definition of the resist composition is as described above.

Examples of a method for forming a resist film on a substrate by the resist composition include a method in which a resist composition is applied to a substrate.

In addition, it is preferable that the resist composition before the application is filtered through a filter, as desired. A pore size of the filter is preferably 0.1 µm or less, more preferably 0.05 µm or less, and still more preferably 0.03 µm or less. In addition, the filter is preferably a polytetrafluoroethylene-made filter, a polyethylene-made filter, or a nylon-made filter.

The resist composition can be applied to a substrate (for example, silicon and silicon dioxide coating) as used in the manufacture of integrated circuit elements by a suitable application method such as an application using a spinner or a coater. The coating method is preferably a spin application using a spinner. A rotation speed upon the spin application using a spinner is preferably 1000 to 3000 rpm.

After the application of the resist composition, the substrate may be dried to form a resist film. In addition, various underlying films (an inorganic film, an organic film, or an antireflection film) may be formed on an underlayer of the resist film.

Examples of the drying method include a method of heating and drying. The heating can be carried out using a unit included in an ordinary exposure machine and/or development machine, and may also be carried out using a hot plate or the like. A heating temperature is preferably 80°C to 150°C, more preferably 80°C to 140°C, and still more preferably 80°C to 130°C. A heating time is preferably 30 to 1000 seconds, more preferably 60 to 800 seconds, and still more preferably 60 to 600 seconds.

A film thickness of the resist film is not particularly limited, but from the viewpoint that a fine pattern having higher accuracy can be formed, is preferably 10 to 65 nm and more preferably 10 to 50 nm.

A topcoat may be formed on the upper layer of the resist film by a topcoat composition.

It is preferable that the topcoat composition is not mixed with the resist film and can be uniformly applied to the upper layer of the resist film.

In addition, it is preferable that the resist film is dried before forming the topcoat. Subsequently, the topcoat composition can be applied to the obtained resist film by the same unit as for the method for forming the resist film described above, and further dried to form a topcoat.

A film thickness of the topcoat is preferably 10 to 200 nm, more preferably 20 to 100 nm, and still more preferably 40 to 80 nm.

The topcoat is not particularly limited, a topcoat known in the related art can be formed by the methods known in the related art, and for example, the topcoat can be formed based on the description in paragraphs [0072] to [0082] of JP2014-059543A.

For example, it is preferable that a topcoat including a basic compound as described in JP2013-61648A is formed on the resist film. Specific examples of the basic compound which can be included in the topcoat include a basic compound which may be included in the resist composition described later.

In addition, it is preferable that the topcoat includes a compound which includes at least one group or bond selected from the group consisting of an ether bond, a thioether bond, a hydroxyl group, a thiol group, a carbonyl bond, and an ester bond.

### <Step 2: Exposing Step>

The step 2 is a step of exposing the resist film with X-rays, electron beam (EB), or extreme ultraviolet rays (EUV light).

Examples of an exposing method include a method in which the formed resist film is irradiated with X-rays, electron beam, or extreme ultraviolet rays through a predetermined mask.

It is preferable to perform baking (heating) before performing development and after the exposure. The baking accelerates a reaction in the exposed portion, and the sensitivity and the pattern shape are improved.

A heating temperature is preferably 80°C to 150°C, more preferably 80°C to 140°C, and still more preferably 80°C to 130°C.

A heating time is preferably 10 to 1000 seconds, more preferably 10 to 180 seconds, and still more preferably 30 to 120 seconds.

The heating can be carried out using a unit included in an ordinary exposure machine and/or development machine, and may also be performed using a hot plate or the like.

This step is also referred to as a post-exposure baking.

### <Step 3: Developing Step>

The step 3 is a step of developing the exposed resist film by a developer to form a pattern.

The developer may be either an alkali developer or a developer containing an organic solvent (hereinafter, also referred to as an organic developer).

Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).

In addition, after the step of performing the development, a step of stopping the development may be carried out while replacing the solvent with another solvent.

A developing time is not particularly limited as long as it is a period of time where the non-exposed portion of the resin is sufficiently dissolved, and is preferably 10 to 300 seconds and more preferably 20 to 120 seconds.

A temperature of the developer is preferably 0°C to 50°C and more preferably 15°C to 35°C.

As the alkali developer, it is preferable to use an aqueous alkali solution including an alkali. The type of the aqueous alkali solution is not particularly limited, and examples thereof include an aqueous alkali solution including a quaternary ammonium salt typified by tetramethylammonium hydroxide, an inorganic alkali, a primary amine, a secondary amine, a tertiary amine, an alcoholamine, a cyclic amine, or the like. Among these, the alkali developer is preferably aqueous solutions of the quaternary ammonium salts typified by tetramethylammonium hydroxide (TMAH). An appropriate amount of alcohols, a surfactant, or the like may be added to the alkali developer. An alkali concentration of the alkali developer is usually 0.1% to 20% by mass. In addition, a pH of the alkali developer is usually 10.0 to 15.0.

The organic developer is preferably a developer containing at least one organic solvent selected from the group consisting of a ketone-based solvent, an ester-based solvent, an alcohol-based solvent, an amide-based solvent, an ether-based solvent, and a hydrocarbon-based solvent.

Examples of the ketone-based solvent include 1-octanone, 2-octanone, 1-nonanone, 2-nonanone, acetone, 2-heptanone (methyl amyl ketone), 4-heptanone, 1-hexanone, 2-hexanone, diisobutyl ketone, cyclohexanone, methylcyclohexanone, phenyl acetone, methyl ethyl ketone, methyl isobutyl ketone, acetyl acetone, acetonyl acetone, ionone, diacetonyl alcohol, acetyl carbinol, acetophenone, methyl naphthyl ketone, isophorone, and propylene carbonate.

Examples of the ester-based solvent include methyl acetate, butyl acetate, ethyl acetate, isopropyl acetate, pentyl acetate, isopentyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate, propyl lactate, butyl butyrate, methyl 2-hydroxyisobutyrate, isoamyl acetate, isobutyl isobutyrate, and butyl propionate.

As the alcohol-based solvent, the amide-based solvent, the ether-based solvent, and the hydrocarbon-based solvent, for example, the solvents described in paragraphs [0715] to [0718] of the specification of US2016/0070167A1 can be used.

A plurality of the above-described solvents may be mixed, or the solvent may be used in admixture with a solvent other than those described above or water. A moisture content in the entire developer is preferably less than 50% by mass, more preferably less than 20% by mass, and still more preferably less than 10% by mass, and it is particularly preferable that the entire developer contains substantially no water.

A content of the organic solvent with respect to the organic developer is preferably 50% by mass to 100% by mass, more preferably 80% by mass to 100% by mass, still more preferably 90% by mass to 100% by mass, and particularly preferably 95% by mass to 100% by mass with respect to the total amount of the developer.

### <Other Steps>

It is preferable that the above-described pattern forming method includes a step of performing washing by a rinsing liquid after the step 3.

Examples of the rinsing liquid used in the rinsing step after the step of performing development by an alkali developer include pure water. An appropriate amount of a surfactant may be added to the pure water. An appropriate amount of a surfactant may be added to the rinsing liquid.

The rinsing liquid used in the rinsing step after the developing step with an organic developer is not particularly limited as long as the rinsing liquid does not dissolve the resist pattern, and a solution including a common organic solvent can be used. As the rinsing liquid, a rinsing liquid containing at least one organic solvent selected from the group consisting of a hydrocarbon-based solvent, a ketone-based solvent, an ester-based solvent, an alcohol-based solvent, an amide-based solvent, and an ether-based solvent is preferably used.

Examples of the hydrocarbon-based solvent, the ketone-based solvent, the ester-based solvent, the alcohol-based solvent, the amide-based solvent, and the ether-based solvent include the same as those described for the developer including an organic solvent.

A method for the rinsing step is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

In addition, the pattern forming method according to the embodiment of the present invention may include a heating step (postbaking) after the rinsing step. By this step, the developer and the rinsing liquid remaining between and inside the patterns are removed by baking. In addition, this step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 seconds to 120 seconds).

In addition, an etching treatment on the substrate may be carried out using the formed pattern as a mask. That is, the substrate (or the underlayer film and the substrate) may be processed using the pattern formed in the step 3 as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step 3 as a mask is preferable.

The dry etching may be one-stage etching or multi-stage etching. In a case where the etching is an etching including a plurality of stages, etchings at the respective stages may be the same treatment or different treatments.

For etching, any of known methods can be used, and various conditions and the like are appropriately determined according to the type of the substrate, usage, and the like. The etching can be carried out, for example, in accordance with Journal of The International Society for Optical Engineering (Proc. of SPIE), Vol. 6924, 692420 (2008), JP2009-267112A, and the like. In addition, the etching can also be carried out in accordance with "Chapter 4 Etching" in "Semiconductor Process Text Book, 4th Ed., published in 2007, publisher: SEMI Japan".

Among these, oxygen plasma etching is preferable as the dry etching.

It is preferable that various materials (for example, the solvent, the developer, the rinsing liquid, a composition for forming the antireflection film, a composition for forming the topcoat, and the like) used in the resist composition and the pattern forming method according to the embodiment of the present invention do not include impurities such as metals. A content of the impurities included in these materials is preferably 1 ppm by mass or less, more preferably 10 ppb by mass or less, still more preferably 100 ppt by mass or less, particularly preferably 10 ppt by mass or less, and most preferably 1 ppt by mass or less. Here, examples of the metal impurities include Na, K, Ca, Fe, Cu, Mg, Al, Li, Cr, Ni, Sn, Ag, As, Au, Ba, Cd, Co, Pb, Ti, V, W, and Zn.

Examples of a method for removing the impurities such as metals from the various materials include filtration using a filter. As for a filter pore diameter, the pore size is preferably less than 100 nm, more preferably 10 nm or less, and still more preferably 5 nm or less. As a filter, a polytetrafluoroethylene-made filter, a polyethylene-made filter, or a nylon-made filter is preferable. The filter may be composed of a composite material in which the above-described filter material is combined with an ion exchange medium. As the filter, a filter which has been washed with an organic solvent in advance may be used. In the step of filter filtration, plural kinds of filters connected in series or in parallel may be used. In a case of using the plural kinds of filters, a combination of filters having different pore diameters and/or materials may be used. In addition, various materials may be filtered plural times, and the step of filtering plural times may be a circulatory filtration step.

In the production of the resist composition, for example, it is preferable to dissolve the respective components such as the resin and the photoacid generator in the solvent, and then perform a circulatory filtration using a plurality of filters having different materials. For example, it is preferable to connect a polyethylene-made filter having a pore diameter of 50 nm, a nylon-made filter having a pore diameter of 10 nm, and a polyethylene-made filter having a pore diameter of 3 nm in permuted connection, and then perform the circulatory filtration ten times or more. A smaller pressure difference between the filters is more preferable, and the pressure difference is generally 0.1 MPa or less, preferably 0.05 MPa or less, and more preferably 0.01 MPa or less. A smaller pressure difference between the filter and the charging nozzle is more preferable, and the pressure difference is generally 0.5 MPa or less, preferably 0.2 MPa or less, and more preferably 0.1 MPa or less.

It is preferable to subject the inside of a device for producing the resist composition to gas replacement with an inert gas such as nitrogen. As a result, it is possible to suppress the dissolution of an active gas such as oxygen in the resist composition.

After being filtered by a filter, the resist composition is charged into a clean container. It is preferable that the resist composition charged in the container is stored in a refrigerator. As a result, performance deterioration over time is suppressed. A shorter time from the completion of charging the composition into the container to the start of the storage in a refrigerator is more preferable, and the time is generally 24 hours or less, preferably 16 hours or less, more preferably 12 hours or less, and still more preferably 10 hours or less. A storage temperature is preferably 0°C to 15°C, more preferably 0°C to 10°C, and still more preferably 0°C to 5°C.

In addition, examples of a method for reducing the impurities such as metals included in the various materials include a method of selecting raw materials having a low content of metals as raw materials constituting the various materials, a method of subjecting raw materials constituting the various materials to filter filtration, and a method of performing distillation under the condition for suppressing the contamination as much as possible by, for example, lining the inside of a device with TEFLON (registered trademark).

In addition to the filter filtration, removal of the impurities by an adsorbing material may be performed, or a combination of filter filtration and an adsorbing material may be used. As the adsorbing material, known adsorbing materials can be used, and for example, inorganic adsorbing materials such as silica gel and zeolite and organic adsorbing materials such as activated carbon can be used. It is necessary to prevent the incorporation of impurities such as metals in the production process in order to reduce the metal impurities included in the above-described various materials. Sufficient removal of the metal impurities from a production device can be confirmed by measuring the content of metal components included in a washing solution used to wash the production device. A content of the metal components included in the washing solution after the use is preferably 100 parts per trillion (ppt) by mass or less, more preferably 10 ppt by mass or less, and still more preferably 1 ppt by mass or less.

A conductive compound may be added to an organic treatment liquid such as the rinsing liquid in order to prevent breakdown of chemical liquid pipes and various parts (a filter, an O-ring, a tube, or the like) due to electrostatic charging, and subsequently generated electrostatic discharging. The conductive compound is not particularly limited, and examples thereof include methanol. An addition amount is not particularly limited, but from the viewpoint that preferred development characteristics or rinsing characteristics are maintained, the addition amount is preferably 10% by mass or less and more preferably 5% by mass or less.

For members of the chemical liquid pipe, for example, various pipes coated with stainless steel (SUS), or a polyethylene, polypropylene, or a fluororesin (a polytetrafluoroethylene resin, a perfluoroalkoxy resin, or the like) that has been subjected to an antistatic treatment can be used. In the same manner, for the filter or the O-ring, polyethylene, polypropylene, or a fluororesin (polytetrafluoroethylene, a perfluoroalkoxy resin, or the like) that has been subjected to an antistatic treatment can be used.

A method for improving the surface roughness of the pattern may be adopted to the pattern formed by the method according to the embodiment of the present invention. Examples of the method for improving the surface roughness of the pattern include the method of treating a pattern by a plasma of a hydrogen-containing gas described in WO2014/002808A. Additional examples of the method include known methods as described in JP2004-235468A, US2010/0020297A, JP2008-83384A, and Proc. of SPIE Vol. 8328 83280N-1 "EUV Resist Curing Technique for LWR Reduction and Etch Selectivity Enhancement".

In addition, the present invention further relates to a method for manufacturing an electronic device, including the above-described pattern forming method, and an electronic device manufactured by this manufacturing method.

The electronic device according to the embodiment of the present invention is suitably mounted on electric and electronic apparatus (for example, home appliances, office automation (OA)-related equipment, media-related equipment, optical equipment, telecommunication equipment, and the like).

### Examples

Hereinafter, the present invention will be described in more detail with reference to Examples. The materials, the amounts of materials used, the proportions, the treatment details, the treatment procedure, and the like shown in Examples below may be appropriately modified as long as the modifications do not depart from the spirit of the present invention. Therefore, the scope of the present invention should not be construed as being limited to Examples shown below.

"part" and "%" are based on mass, unless otherwise noted.

### [Various Components of Positive Tone Resist Composition]

### [Resin (B)]

### <Synthesis of Resin A-1>

18.7 g, 11.8 g, and 2.60 g, in order from the left side, of monomers corresponding to the respective repeating units of a resin A-1 and a polymerization initiator V-601 (manufactured by FUJIFILM Wako Pure Chemical Corporation) (0.0461 g) were dissolved in cyclohexanone (5.37 g). A solution thus obtained was used as a monomer solution.

Cyclohexanone (2.89 g) was put into a reaction container, and the monomer solution was added dropwise thereto over 4 hours in a nitrogen gas atmosphere in the reaction container adjusted to a temperature of 85°C. The obtained reaction solution was stirred at 85°C for 2 hours in the reaction container, and then left to be cooled until the temperature reached room temperature (23°C).

The reaction solution after being left to be cooled was added dropwise to methanol over 20 minutes, and the precipitated powder was filtered. The obtained powder was dried to obtain a resin A-1 (16.6 g).

As resins A-1 to A-20, those synthesized according to the above-described method synthetic example of the resin A-1 were used. With regard to each resin, a compositional ratio (molar ratio; corresponding in order from the left) of each repeating unit, a weight-average molecular weight (Mw), and a dispersity (Mw/Mn) are shown in Table 1.

The weight-average molecular weight (Mw) and the dispersity (Mw/Mn) of the resins A-1 to A-20 were measured by GPC (solvent: tetrahydrofuran (THF)) (an amount expressed in terms of polystyrene). In addition, the compositional ratio (ratio in mol%) of the resin was measured by means of ¹³C-nuclear magnetic resonance (NMR).

Although resins (RA-1) to (RA-3) are not the resin (B), they are listed in Table 1 for convenience.

**[Table 1]**

| | Molar ratio of repeating unit | | | | Mw | Mw/Mn |
|---|---|---|---|---|---|---|
| Resin A-1 | 40 | 50 | 10 | - | 63000 | 1.62 |
| Resin A-2 | 50 | 40 | 10 | - | 58500 | 1.58 |
| Resin A-3 | 45 | 50 | 5 | - | 62100 | 1.55 |
| Resin A-4 | 45 | 50 | 5 | - | 45000 | 1.66 |
| Resin A-5 | 50 | 50 | - | - | 49500 | 1.54 |
| Resin A-6 | 50 | 35 | 15 | - | 60500 | 1.63 |
| Resin A-7 | 50 | 45 | 5 | - | 56300 | 1.59 |
| Resin A-8 | 40 | 50 | 10 | - | 57000 | 1.49 |
| Resin A-9 | 45 | 50 | 5 | - | 68000 | 1.66 |
| Resin A-10 | 50 | 40 | 10 | - | 49000 | 1.60 |
| Resin A-11 | 47 | 45 | 5 | 3 | 52500 | 1.71 |
| Resin A-12 | 45 | 40 | 10 | 5 | 63000 | 1.70 |
| Resin A-13 | 45 | 45 | 5 | 5 | 55400 | 1.69 |
| Resin A-14 | 46 | 35 | 15 | 4 | 57600 | 1.72 |
| Resin A-15 | 40 | 50 | 10 | - | 55300 | 1.66 |
| Resin A-16 | 45 | 50 | 5 | - | 60500 | 1.61 |
| Resin A-17 | 5 | 45 | 45 | 5 | 52000 | 1.75 |
| Resin A-18 | 50 | 50 | - | - | 49900 | 1.49 |
| Resin A-19 | 25 | 50 | 25 | - | 50100 | 1.66 |
| Resin A-20 | 50 | 20 | 30 | - | 60100 | 1.59 |
| Resin RA-1 | 50 | 50 | - | - | 60000 | 1.55 |
| Resin RA-2 | 60 | 40 | - | - | 9500 | 1.55 |
| Resin RA-3 | 100 | - | - | - | 9000 | 1.23 |

Structural formulae of the resins A-1 to A-20 and RA-1 to RA-3 shown in Table 1 are shown below.

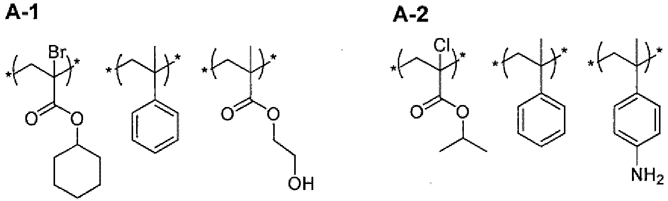

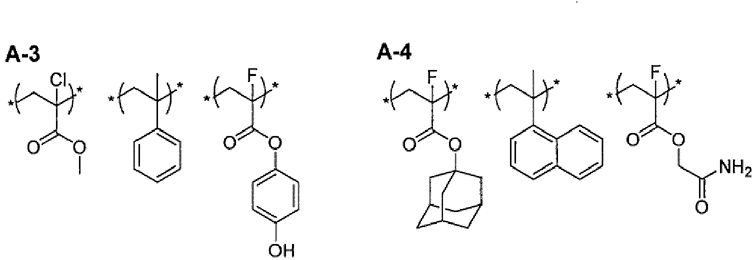

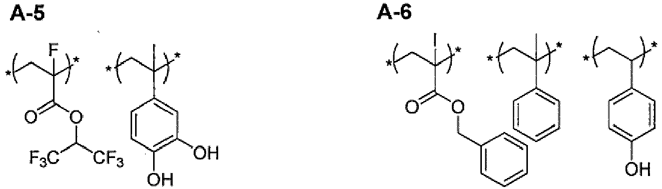

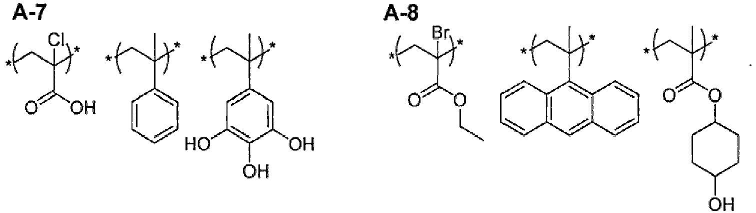

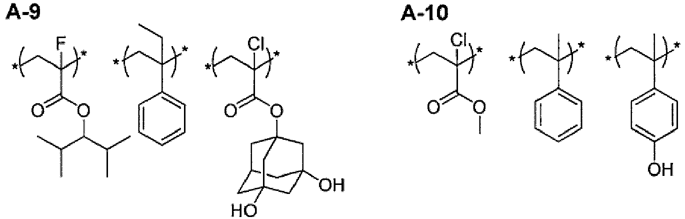

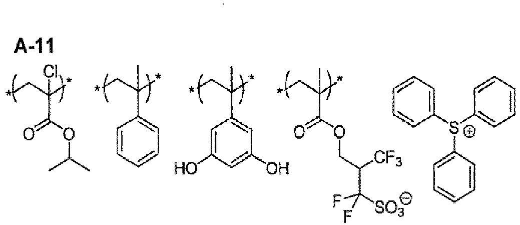

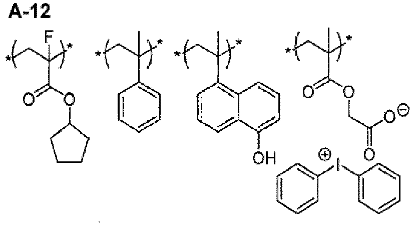

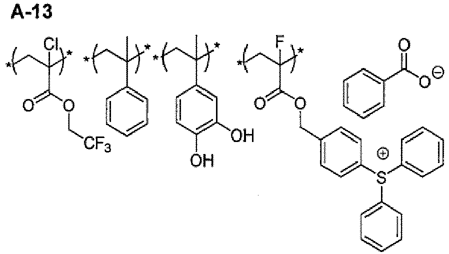

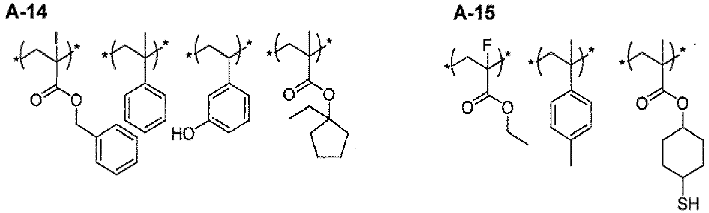

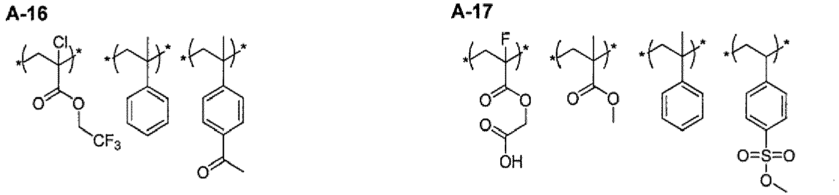

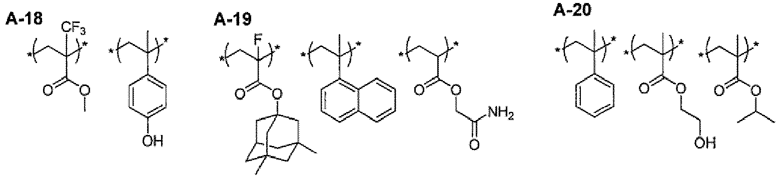

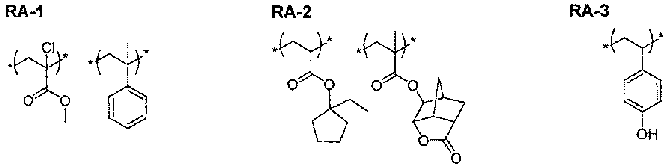

### [Ionic Compound (A)]

Structures of ionic compounds (compounds B-1 to B-15) shown in Table 2 are shown below.

Although the compound B'-1 is not the ionic compound (A), it is listed below for convenience.

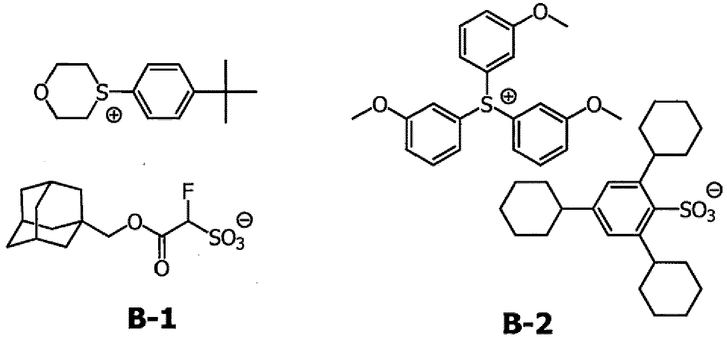

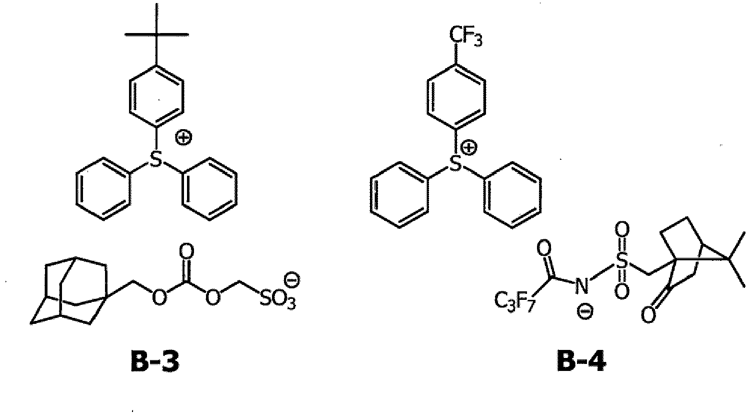

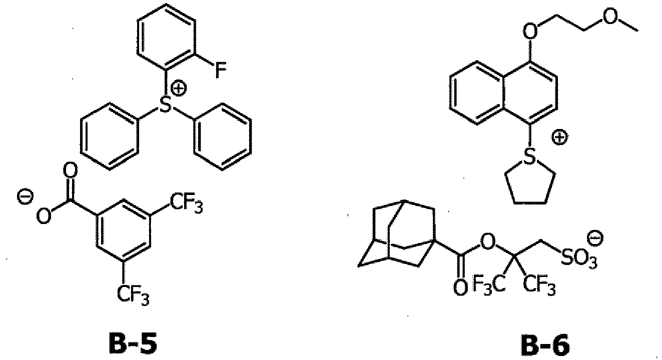

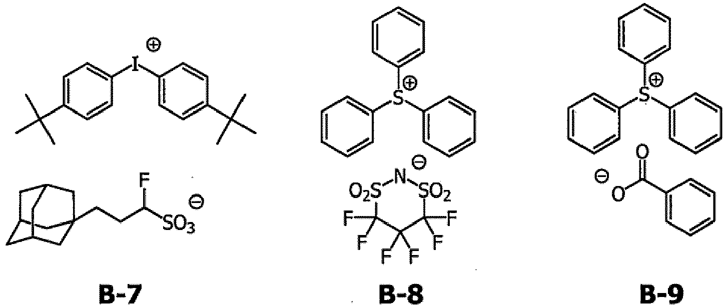

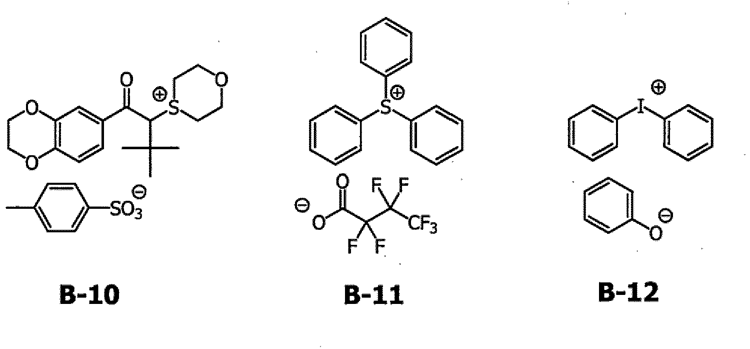

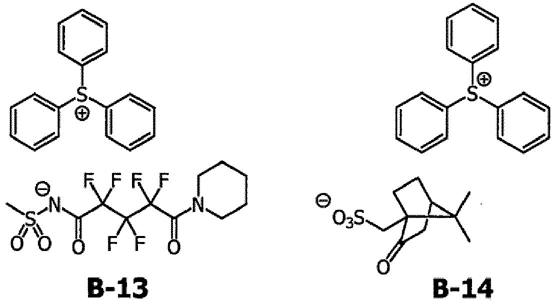

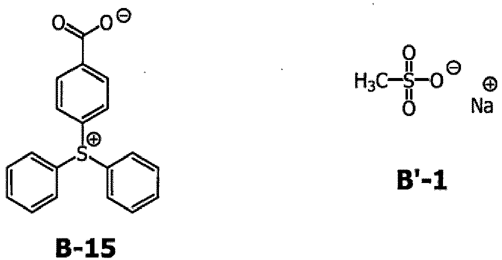

### [Acid Diffusion Control Agent]

A structure of an acid diffusion control agent (compound C-1) shown in Table 2 is shown below.

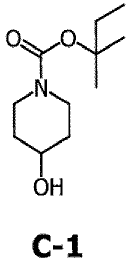

### [Solvent]

Solvents shown in Table 2 are shown below.
F-1: Propylene glycol monomethyl ether acetate (PGMEA)
F-2: Propylene glycol monomethyl ether (PGME)
F-3: Cyclohexanone
F-4: Ethyl lactate
F-5: γ-Butyrolactone
F-6: Anisole

### <Developer>

Developers in a case of an organic solvent development, shown in Table 3, are shown below.
G-1: n-butyl acetate
G-2: Isoamyl acetate
G-3: Hexyl acetate

### [Preparation of Positive Tone Resist Composition]

Respective components shown in Table 2 were mixed so that a concentration of solid contents was 2% by mass. Next, the obtained mixed liquid was filtered through firstly a polyethylene-made filter having a pore diameter of 50 nm, a nylon-made filter having a pore diameter of 10 nm, and lastly a polyethylene-made filter having a pore diameter of 5 nm in this order to prepare a positive tone resist composition (hereinafter, also referred to as a resist composition). In the resist composition, the solid content means all the components excluding the solvent. The obtained resist compositions were used in Examples and Comparative Examples.

In Table 2, the content (% by mass) of each component means a content with respect to the total solid content.

**[Table 2]**

| Resist composition | Resin (B) | | Ionic com pound (A) | | Acid diffusion control agent | | Solvent | |
|---|---|---|---|---|---|---|---|---|
| | Type | % by mass | Type | % by mass | Type | % by mass | Type | Mixed ratio (mass ratio) |
| Re-1 | A-1 | 93.1 | B-6 | 6.9 | - | - | F-1/F-2/F-5 | 40/30/30 |
| Re-2 | A-2 | 92.5 | B-3 | 7.5 | - | - | F-1/F-2 | 60/40 |
| Re-3 | A-3 | 90.4 | B-12 | 9.6 | - | - | F-1/F-2/F-5 | 40/30/30 |
| Re-4 | A-4 | 85.5 | B-10 | 14.5 | - | - | F-1/F-2/F-4 | 50/30/20 |
| Re-5 | A-5 | 90.4 | B-1 | 9.6 | - | - | F-1/F-2/F-5 | 40/30/30 |
| Re-6 | A-6 | 87.0 | B-15 | 13.0 | - | - | F-1/F-2 | 60/40 |
| Re-7 | A-7 | 96.1 | B-2 | 3.9 | - | - | F-1/F-2/F-4 | 50/30/20 |
| Re-8 | A-8 | 97.0 | B-4 | 3.0 | - | - | F-1/F-2/F-4 | 50/30/20 |
| Re-9 | A-9 | 92.1 | B-5 | 7.9 | - | - | F-1/F-2 | 60/40 |
| Re-10 | A-10 | 90.4 | B-9 | 9.6 | - | - | F-1/F-2/F-5 | 40/30/30 |
| Re-11 | A-3 | 90.4 | B-8 | 9.6 | - | - | F-1/F-2/F-5 | 40/30/30 |
| Re-12 | A-10 | 82.7 | B-13 | 17.3 | - | - | F-1/F-2/F-5 | 40/30/30 |
| Re-13 | A-5 | 90.4 | B-11/B-10 | 4.5/5.1 | - | - | F-1/F-2/F-5 | 40/30/30 |
| Re-14 | A-2 | 85.6 | B-7 | 13.9 | C-1 | 0.5 | F-1/F-2/F-5 | 40/30/30 |
| Re-15 | A-11 | 100.0 | - | - | - | - | F-1/F-2/F-5 | 40/30/30 |
| Re-16 | A-12 | 100.0 | - | - | - | - | F-1/F-2/F-5 | 40/30/30 |
| Re-17 | A-13 | 100.0 | - | - | - | - | F-1/F-2/F-5 | 40/30/30 |
| Re-18 | A-14 | 92.8 | B-14 | 7.2 | - | - | F-1/F-2/F-4 | 50/30/20 |
| Re-19 | A-15 | 93.0 | B-12 | 7.0 | - | - | F-1/F-2/F-5 | 40/30/30 |
| Re-20 | A-16 | 95.6 | B-1 | 4.4 | - | - | F-1/F-2/F-4 | 50/30/20 |
| Re-21 | A-17 | 88.8 | B-7 | 11.2 | - | - | F-1/F-2 | 60/40 |
| Re-22 | A-18 | 91.4 | B-11 | 8.6 | - | - | F-1/F-2/F-5 | 40/30/30 |
| Re-23 | A-4/A-11 | 80.0/20.0 | - | - | - | - | F-1/F-2 | 60/40 |
| Re-24 | A-12 | 97.8 | B-4 | 2.2 | - | - | F-1/F-2/F-5 | 40/30/30 |
| Re-25 | A-19 | 78.5 | B-9 | 21.5 | - | - | F-1/F-2/F-5 | 40/30/30 |
| Re-26 | A-20 | 82.2 | B-6 | 17.8 | - | - | F-1/F-2/F-5 | 40/30/30 |
| Re-27 | RA-1 | 100.0 | - | - | - | - | F-6 | 100 |
| Re-28 | RA-2 | 85.0 | B-8 | 14.5 | C-l | 0.5 | F-1/F-2 | 80/20 |
| Re-29 | RA-3 | 91.0 | B-14 | 9.0 | - | - | F-1/F-2/F-3 | 45/30/25 |
| Re-30 | A-19 | 86.0 | B'-1 | 14.0 | - | - | F-1/F-2 | 80/20 |

### <Pattern Formation (1): EUV Exposure and Organic Solvent Development>

A composition for forming an underlayer film, AL412 (manufactured by Brewer Science, Inc.), was applied to a silicon wafer and baked at 205°C for 60 seconds to form an underlying film having a film thickness of 20 nm. A resist composition shown in Table 3 was applied thereto and baked at 100°C for 60 seconds to form a resist film having a film thickness of 30 nm.

The silicon wafer having the obtained resist film was subjected to a pattern irradiation using an EUV exposure device (manufactured by Exitech Ltd., Micro Exposure Tool, NA 0.3, Quadrupol, outer sigma 0.68, inner sigma 0.36). As a reticle, a mask having a line size = 22 nm and a line:space = 1:1 was used.

The resist film after the exposure was baked at 90°C for 60 seconds, developed with a developer shown in Table 3 for 30 seconds, and spin-dried to obtain a positive tone pattern.

### [Evaluation]

### <Resolution>

Under the exposure and development conditions for forming the resist pattern, in a case where an optimum exposure amount was set as the exposure amount that reproduced the mask pattern having a line width of 22 nm, and a line width of a line-and-space pattern formed by further increasing the exposure amount from the optimum exposure amount was narrowed, the minimum line width at which the pattern could be resolved without breaking was defined as a value (nm) indicating resolution. As the value indicating the resolution is smaller, the finer pattern is resolved, and resolving power is higher. More specifically, the resolution is preferably 20 nm or less, more preferably 16 nm or less, and still more preferably 15 nm or less.

### (Evaluation Result)

The results of the evaluation tests are shown in Table 3 below.

**[Table 3]**

| | Composition | Developer | Evaluation item Resolution |
|---|---|---|---|
| Example 1-1 | Re-1 | G-1 | 15 |
| Example 1-2 | Re-2 | G-1 | 15 |
| Example 1-3 | Re-3 | G-2 | 15 |
| Example 1-4 | Re-4 | G-1 | 15 |
| Example 1-5 | Re-5 | G-1 | 20 |
| Example 1-6 | Re-6 | G-2 | 19 |
| Example 1-7 | Re-7 | G-3 | 16 |
| Example 1-8 | Re-8 | G-3 | 17 |
| Example 1-9 | Re-9 | G-2 | 15 |
| Example 1-10 | Re-10 | G-1 | 15 |
| Example 1-11 | Re-11 | G-1 | 19 |
| Example 1-12 | Re-12 | G-1 | 16 |
| Example 1-13 | Re-13 | G-2 | 20 |
| Example 1-14 | Re-14 | G-1 | 15 |
| Example 1-15 | Re-15 | G-2 | 16 |
| Example 1-16 | Re-16 | G-1 | 16 |
| Example 1-17 | Re-17 | G-1 | 16 |
| Example 1-18 | Re-18 | G-1 | 16 |
| Example 1-19 | Re-19 | G-1 | 15 |
| Example 1-20 | Re-20 | G-1 | 20 |
| Example 1-21 | Re-21 | G-2 | 20 |
| Example 1-22 | Re-22 | G-1 | 20 |
| Example 1-23 | Re-23 | G-1 | 17 |
| Example 1-24 | Re-24 | G-1 | 18 |
| Example 1-25 | Re-25 | G-1 | 19 |
| Example 1-26 | Re-26 | G-1 | 20 |
| Comparative Example 1-1 | Re-27 | G-3 | 22 |
| Comparative Example 1-2 | Re-28 | G-1 | Without resolution |
| Comparative Example 1-3 | Re-29 | G-1 | 22 |
| Comparative Example 1-4 | Re-30 | G-1 | Without resolution |

From the results in Table 3, with the positive tone resist composition according to the embodiment of the present invention, in a formation of ultrafine pattern, it is possible to form a pattern having extremely excellent resolution.

### <Pattern Formation (2): EUV Exposure and Aqueous Alkali Solution Development>

A composition for forming an underlayer film, AL412 (manufactured by Brewer Science, Inc.), was applied to a silicon wafer and baked at 205°C for 60 seconds to form an underlying film having a film thickness of 20 nm. A resist composition shown in Table 4 was applied thereto and baked at 100°C for 60 seconds to form a resist film having a film thickness of 30 nm.

The silicon wafer having the obtained resist film was subjected to a pattern irradiation using an EUV exposure device (manufactured by Exitech Ltd., Micro Exposure Tool, NA 0.3, Quadrupol, outer sigma 0.68, inner sigma 0.36). As a reticle, a mask having a line size = 32 nm and a line:space = 1:1 was used.

The resist film after the exposure was baked at 90°C for 60 seconds, developed with an aqueous tetramethylammonium hydroxide solution (2.38% by mass) for 30 seconds, and then rinsed with pure water for 30 seconds. Thereafter, the resist film was spin-dried to obtain a positive tone pattern.

### [Evaluation]

### <Resolution>

Under the exposure and development conditions for forming the resist pattern, in a case where an optimum exposure amount was set as the exposure amount that reproduced the mask pattern having a line width of 32 nm, and a line width of a line-and-space pattern formed by further increasing the exposure amount from the optimum exposure amount was narrowed, the minimum line width at which the pattern could be resolved without breaking was defined as a value (nm) indicating resolution. As the value indicating the resolution is smaller, the finer pattern is resolved, and resolving power is higher. More specifically, the resolution is preferably 30 nm or less, more preferably 26 nm or less, and still more preferably 24 nm or less.

### Examples 2-1 to 2-26 were further evaluated for development defect as follows.

### <Development Defect>

With regard to the pattern formed as described above on a silicon wafer (12 inch diameter), using a defect inspection apparatus KLA 2360 (trade name) manufactured by KLA Tencor Ltd., the pattern was measured in random mode by setting a pixel size of the defect inspection apparatus to 0.16 µm and a threshold value to 20, and the number of development defects per unit area (pieces/cm²) was calculated by detecting development defects extracted from a difference caused by a superposition of a comparative image and a pixel unit. 1 inch is 0.0254 m. A value of less than 0.5 is defined as A, a value of 0.5 or more and less than 0.7 is defined as B, a value of 0.7 or more and less than 1.0 is defined as C, and a value of 1.0 or more is defined as D. As the value is smaller, the performance is better.

### (Evaluation Result)

The results of the evaluation tests are shown in Table 4 below.

**[Table 4]**

| | Composition | Evaluation item Resolution | Evaluation item Development defect |
|---|---|---|---|
| Example 2-1 | Re-1 | 25 | B |
| Example 2-2 | Re-2 | 24 | B |
| Example 2-3 | Re-3 | 25 | C |
| Example 2-4 | Re-4 | 25 | C |
| Example 2-5 | Re-5 | 30 | A |
| Example 2-6 | Re-6 | 29 | A |
| Example 2-7 | Re-7 | 25 | A |
| Example 2-8 | Re-8 | 27 | B |
| Example 2-9 | Re-9 | 25 | C |
| Example 2-10 | Re-10 | 24 | B |
| Example 2-11 | Re-11 | 29 | C |
| Example 2-12 | Re-12 | 26 | B |
| Example 2-13 | Re-13 | 30 | A |
| Example 2-14 | Re-14 | 24 | B |
| Example 2-15 | Re-15 | 26 | C |
| Example 2-16 | Re-16 | 26 | B |
| Example 2-17 | Re-17 | 26 | C |
| Example 2-18 | Re-18 | 25 | A |
| Example 2-19 | Re-19 | 25 | B |
| Example 2-20 | Re-20 | 30 | C |
| Example 2-21 | Re-21 | 30 | B |
| Example 2-22 | Re-22 | 30 | A |
| Example 2-23 | Re-23 | 27 | B |
| Example 2-24 | Re-24 | 28 | B |
| Example 2-25 | Re-25 | 29 | A |
| Example 2-26 | Re-26 | 30 | A |
| Comparative Example 2-1 | Re-27 | Without resolution | - |
| Comparative Example 2-2 | Re-28 | 32 | - |
| Comparative Example 2-3 | Re-29 | 32 | - |
| Comparative Example 2-4 | Re-30 | Without resolution | - |

From the results in Table 4, it was found that the positive tone resist composition according to the embodiment of the present invention is extremely excellent in resolution in a formation of ultrafine pattern. In addition, it was also found that, in a case of developing with an alkali developer, the resolution is extremely excellent and the development defects are reduced.

According to the present invention, it is possible to provide a positive tone resist composition with which, in a formation of ultrafine pattern (for example, 40 nm or less), it is possible to form a pattern having extremely excellent resolution.

In addition, according to the present invention, it is possible to provide a resist film formed of the positive tone resist composition, a pattern forming method, and a method for manufacturing an electronic device.

The present invention has been described in detail with reference to specific embodiments. To those skilled in the art, it is obvious that various changes or modifications can be added without departing from the gist and scope of the present invention.

The present application is based on Japanese Patent Application (Patent Application No. 2020-015892) filed on January 31, 2020, the contents of which are incorporated herein by reference.

## Claims

1. A positive tone resist composition comprising:
(A) an ionic compound; and
(B) a resin that has a repeating unit (b1) having an interactive group which interacts with an ionic group in the ionic compound and of which a main chain is decomposed by an irradiation with X-rays, electron beam, or extreme ultraviolet rays.

2. The positive tone resist composition according to claim 1,
wherein the resin (B) has, as the interactive group, at least one selected from the group consisting of a hydroxyl group, an amino group, an amide group, and a thiol group.

3. The positive tone resist composition according to claim 1 or 2,
wherein the resin (B) has a repeating unit represented by the following General Formula (1), 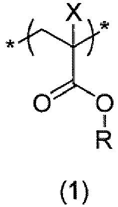 in the General Formula (1),
X represents a halogen atom or a fluoroalkyl group, and
R represents a hydrogen atom or a monovalent organic group.

4. The positive tone resist composition according to claim 3,
wherein X in the General Formula (1) represents a fluorine atom, a chlorine atom, or a bromine atom.

5. The positive tone resist composition according to any one of claims 1 to 4,
wherein the ionic compound (A) and the resin (B) are the same compound.

6. The positive tone resist composition according to claim 5,
wherein the resin (B) has a repeating unit represented by the following General Formula (3) as the repeating unit (b1), and has at least one repeating unit selected from the group consisting of a repeating unit represented by the following General Formula (4) and a repeating unit represented by the following General Formula (5), 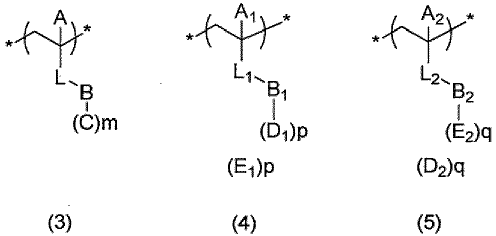
in the General Formula (3),
A represents a hydrogen atom, a halogen atom, or an alkyl group,
L represents a divalent linking group,
B represents a single bond or an (m+1)-valent linking group,
C represents the interactive group,
m represents an integer of 1 or more, and
in a case where m is an integer of 2 or more, a plurality of C's may be the same or different from each other,
in the General Formula (4),
A₁ represents a hydrogen atom, a halogen atom, or an alkyl group,
L₁ represents a single bond or a divalent linking group,
B₁ represents a single bond or a (p+1)-valent linking group,
D₁ represents an anionic group,
E₁ represents a cation,
p represents an integer of 1 or 2, and
in a case where p is an integer of 2, a plurality of D₁'s and a plurality of E₁'s each may be the same or different from each other, and
in the General Formula (5),
A2 represents a hydrogen atom, a halogen atom, or an alkyl group,
L2 represents a divalent linking group,
B2 represents a single bond or a (q+1)-valent linking group,
D₂ represents an anion,
E2 represents a cationic group,
q represents an integer of 1 or 2, and
in a case where q is an integer of 2, a plurality of D₂'s and a plurality of E₂'s each may be the same or different from each other.

7. The positive tone resist composition according to any one of claims 1 to 6,
wherein the repeating unit (b1) is a repeating unit represented by General Formula (2), 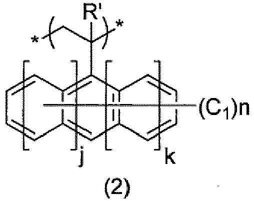 in the General Formula (2),
R' represents a hydrogen atom or an alkyl group,
C₁ represents the interactive group,
j represents 0 or 1,
k represents 0 or 1,
n represents an integer of 1 to 9, and
in a case where n is an integer of 2 to 9, a plurality of C₁'s may be the same or different from each other.

8. The positive tone resist composition according to any one of claims 1 to 7,
wherein a content of the repeating unit (b1) is 20 mol% or less with respect to all repeating units of the resin (B).

9. The positive tone resist composition according to any one of claims 1 to 8,
wherein the resin (B) has a repeating unit represented by the following General Formula (7) (excluding a repeating unit corresponding to a repeating unit represented by the General Formula (2)), 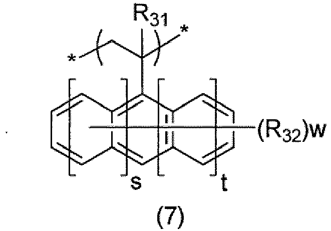 in the General Formula (7),
R₃₁ represents a hydrogen atom or an alkyl group,
R32 represents a monovalent organic group,
s represents 0 or 1,
t represents 0 or 1,
w represents an integer of 0 to 9, and
in a case where w is an integer of 2 to 9, a plurality of R₃₂'s may be the same or different from each other.

10. The positive tone resist composition according to any one of claims 1 to 9,
wherein the ionic compound (A) is a compound represented by the following General Formula (6), 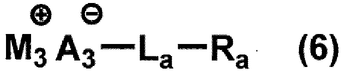 in the General Formula (6),
M₃⁺ represents an organic cation which is decomposed by an irradiation with X-rays, electron beam, or extreme ultraviolet rays,
A₃⁻ represents an anionic group,
Ra represents a hydrogen atom or a monovalent organic group, and
La represents a single bond or a divalent linking group.

11. The positive tone resist composition according to claim 10,
wherein the ionic compound (A) and the resin (B) are the same compound, and
the monovalent organic group as Ra in the compound represented by the General Formula (6) includes a main chain structure of the resin.

12. The positive tone resist composition according to claim 10 or 11,
wherein A₃⁻ in the compound represented by the General Formula (6) is a group selected from the group consisting of groups represented by the following General Formulae (B-1) to (B-14), 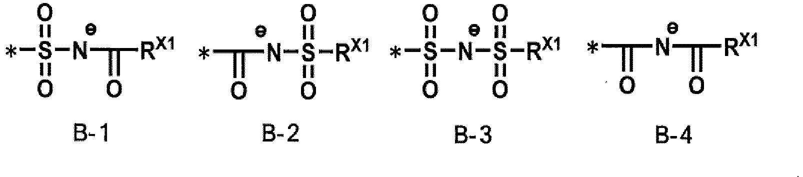 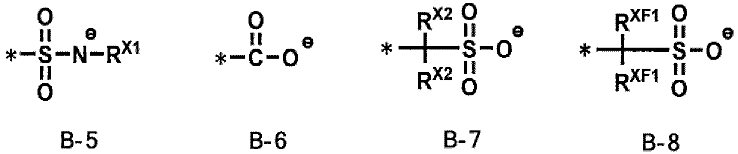 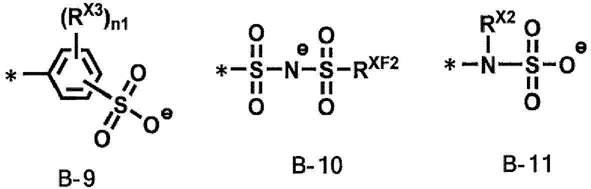 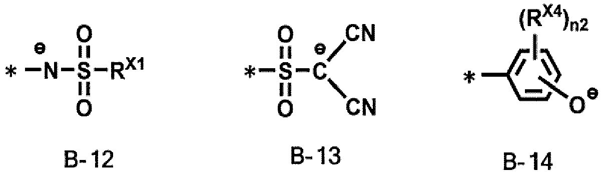
in the Formulae (B-1) to (B-14), ^{∗} represents a bonding position,
in the Formulae (B-1) to (B-5) and (B-12), R^{X1}'s each independently represent a monovalent organic group,
in the Formulae (B-7) and (B-11), R^{X2}'s each independently represent a hydrogen atom or a substituent other than a fluorine atom and a perfluoroalkyl group, two R^{X2}'s in the Formula (B-7) may be the same or different from each other,
in the General Formula (B-8), R^{XF1} represents a hydrogen atom, a fluorine atom, or a perfluoroalkyl group, at least one of a plurality of R^{XF1}'s represents a fluorine atom or a perfluoroalkyl group, and two R^{XF1}'s in the Formula (B-8) may be the same or different from each other,
in the General Formula (B-9), R^{X3} represents a hydrogen atom, a halogen atom, or a monovalent organic group, n1 represents an integer of 0 to 4, and in a case where n1 represents an integer of 2 to 4, a plurality of R^{X3}'s may be the same or different from each other,
in the General Formula (B-10), R^{XF2} represents a fluorine atom or a perfluoroalkyl group, and
in the General Formula (B-14), R^{X4} represents a hydrogen atom, a halogen atom, or a monovalent organic group, n2 represents an integer of 0 to 4, and in a case where n2 represents an integer of 2 to 4, a plurality of R^{X4}'s may be the same or different from each other.

13. The positive tone resist composition according to claim 12,
wherein A₃⁻ in the compound represented by the General Formula (6) is a group selected from the group consisting of the groups represented by the General Formulae (B-6), (B-7), (B-8), (B-9), and (B-14).

14. A resist film formed of the positive tone resist composition according to any one of claims 1 to 13.

15. A pattern forming method comprising:
a step of forming a resist film on a substrate by the positive tone resist composition according to any one of claims 1 to 13;
a step of exposing the resist film with X-rays, electron beam, or extreme ultraviolet rays; and
a step of developing the exposed resist film by a developer to form a pattern.

16. A method for manufacturing an electronic device, comprising:
the pattern forming method according to claim 15.
